# EUROPEAN PATENT APPLICATION

(11) **EP 4 261 015 A1**
(43) Date of publication of application: **18.10.2023**
(21) Application number: 22912784.0
(22) Date of filing: 28.10.2022
(51) Int. Cl.: B29C 64/35, B29C 64/393, B29C 64/209, B29C 64/232, B33Y 30/00, B33Y 40/00

(54) **PRINTING APPARATUS AND METHOD FOR LED DAM OF DISPLAY PANEL**

(30) Priority: 03.03.2022 CN 202210203951; 24.03.2022 CN 202210292190
(71) Applicant: ENOVATE3D (HANGZHOU) TECHNOLOGY DEVELOPMENT CO., LTD., Hangzhou, Zhejiang 310051 (CN)
(72) Inventor: The designation of the inventor has not yet been filed
(74) Representative: Fezzardi, Antonio
(86) International application number: PCT/CN2022/128177
(87) International publication number: WO 2023/165147

(57) **Abstract**

Provided are a printing device and method for an LED retaining wall of a display panel. The device includes a motion control system, an adsorption apparatus, a measuring system, a Z-axis controller, a target multi-needle module and a target station. The motion control system is configured to control printing of a target LED retaining wall on an upper surface of a target substrate on the target station. The adsorption apparatus is configured to make a lower surface of the target substrate adsorbed onto a sucker by a vacuum pump. The measuring system includes a sensor and a sensor controller, and the sensor is configured to measure flatness data of the target substrate. The Z-axis controller is configured to control a printing receiving distance between the target multi-needle module and the upper surface of the target substrate. The target multi-needle module includes printer heads and fluid control systems, and the fluid control systems are configured to supply preset air pressure parameters to the printer heads. The target station is configured to accommodate the target substrate so as to make the target multi-needle module perform laminated printing of the target LED retaining wall on the upper surface of the target substrate. By the adoption of the printing device and method for the LED retaining wall of the display panel provided by the present disclosure, the manufacturing efficiency and precision of the LED retaining wall are improved.

## Description

### TECHNICAL FIELD

The present disclosure relates to the technical field of machining of display panels, in particular to a printing device and method for an LED (Light Emitting Diode) retaining wall of a display panel.

### BACKGROUND ART

Mini-LEDs (Mini-Light Emitting Diodes) and Micro-LEDs (Micro-Light Emitting Diodes) have the display advantages such as high luminous efficiency and contrast and the characteristics of long service life and stable performance. Meanwhile, they will be mainstream display technologies for replacing LCDs (Liquid Crystal Displays) and OLEDs (Organic Light-Emitting Diodes) in the future due to their relatively simple manufacturing processes and technical contours.

At present, the technology for manufacturing blue light diodes by selecting gallium nitride is mature, while the manufacturing cost of red light diodes is high and the effect is poor. Thus, the blue light diodes will emit red or green light by dispensing trans chromatic particles (red fluorescent powder or green fluorescent powder) onto the blue light diodes at the current stage. In order to prevent colour mixing of the trans chromatic particles in different colours at adjacent subpixels, retaining walls are required to be built around each group of LEDs, so as to prevent colour mixing caused by contact of different trans chromatic particles during injection, thereby improving colour purity.

Although inorganic LEDs are in a trend of miniaturization, their sizes are still at tens of microns. Heights of LEDs of Mini-LED products are about 110 µm, heights of retaining walls are required to be greater than 120 µm, and the retaining walls are required to be manufactured by a traditional photolithographic process through the steps such as gluing/exposure/developing. It takes more than 100 minutes to manufacture a single panel retaining wall at a rate of 1 µm/min, which is extremely low in efficiency and cannot ensure the consistency of widths and heights. Gaps between LEDs of the Micro-LED products are smaller, so that it will be of great challenge to apply the traditional photolithographic process to manufacturing Micro-LED retaining walls.

Light emitting diodes, short for LEDs, are common luminescent devices, which emit light by combining electrons with holes to release energy. The LEDs can efficiently convert electric energy into light energy, and have wide applications, such as illumination, panel display and medical devices, in modern society.

Wherein, adding retaining walls to LED display screens is a method capable of effectively improving luminous performance of the display screens. The retaining walls are required to be manufactured in slots between the LEDs and have certain heights, positional precision and consistency requirements.

Existing retaining wall manufacturing solutions include silk-screen printing, transfer printing and the like, and no report about manufacturing the retaining walls via 3D (three-dimensional) printing has been disclosed yet. The process for manufacturing the retaining walls via silk-screen printing is only suitable for planar base materials, and the printing width-height ratio thereof is small, so that the retaining walls are required to be manufactured through repeated printing and curing; during forming, the multi-alignment difficulty is high, and the yield remains to be seen; and the minimum width of a printing line is large, and such process is usually only suitable for the planar base materials. The process for manufacturing the retaining walls via transfer printing also has the problems of high transfer printing alignment difficulty, large width-height ratio, difficult line transfer printing and the like.

A method for manufacturing an LED packaging retaining wall with the Chinese patent number of CN201210166648.7 has been disclosed. The method includes the following steps: providing a ceramic substrate, a soft mould and a photosensitive ceramic slurry; forming a plurality of groups of electrodes on the ceramic substrate; filling model grooves with the photosensitive ceramic slurry; pressing the soft mould on the ceramic substrate after enabling the model grooves filled with the photosensitive ceramic slurry to be respectively right opposite to the groups of electrodes; curing the photosensitive ceramic slurry in the model grooves through a UV (ultraviolet) hardening method to form the retaining wall while pressing the soft mould, so that the photosensitive ceramic slurry is fixedly bonded with the ceramic substrate while being cured to form the retaining wall; and removing the soft mould.

According to the method for manufacturing the retaining wall disclosed above, the LED packaging retaining wall is manufactured through the mould, the manner disclosed above has limited precision due to small diodes, such that the method is not suitable for printing the LED retaining wall, the yield is low, and neither a carrier module nor how to realize better positioning of the diodes during printing is disclosed in the manner disclosed above.

### SUMMARY

### TECHNICAL PROBLEMS

The present disclosure provides a printing device and method for an LED retaining wall of a display panel, so as to overcome the defect that retaining walls with high precision cannot be manufactured in narrow LED gaps in the prior art and realize high manufacturing efficiency and precision of the LED retaining wall.

The present disclosure provides a printing device for an LED retaining wall of a display panel, including:
a motion control system, connected with a control terminal and configured to control printing of a target LED retaining wall on an upper surface of a target substrate on a target station;
an adsorption apparatus, connected with the motion control system and configured to make a lower surface of the target substrate adsorbed onto a sucker by a vacuum pump;
a measuring system, connected with the control terminal and comprising a sensor and a sensor controller, the sensor being configured to measure flatness data of the target substrate;
a Z-axis controller, connected with the control terminal and configured to control a printing receiving distance between a target multi-needle module and the upper surface of the target substrate;
the target multi-needle module, connected with the Z-axis controller and comprising printer heads and fluid control systems, the fluid control systems being configured to supply preset air pressure parameters to the printer heads; and
the target station, connected with the motion control system and configured to accommodate the target substrate so as to make the target multi-needle module perform laminated printing of the target LED retaining wall on the upper surface of the target substrate;
wherein, the target station includes a first station and/or a second station, the target LED retaining wall includes transversal LED retaining walls and longitudinal LED retaining walls, the target multi-needle module includes a first module and/or a second module, the first module is matched with the first station, the second module is matched with the second station, and the target substrate includes a PCB (Printed Circuit Board) substrate or a glass substrate.

According to the printing device for the LED retaining wall of the display panel provided by the present disclosure, the target station further includes:
a cleaning zone, configured to clean and store the printer heads; and
a pre-printing zone where pre-printing is performed under the preset air pressure parameters till the printer heads deliver the materials stably, and then the adsorption apparatus is controlled by the motion control system to leave the pre-printing zone.

According to the printing device for the LED retaining wall of the display panel provided by the present disclosure, the motion control system is specifically configured to control the adsorption apparatus to move in an XY plane under the condition that the target station includes the first station and the second station, so that the first module prints the longitudinal LED retaining walls on the target substrate in the first station; and
send a first motion instruction to the adsorption apparatus, so that the adsorption apparatus transfers the target substrate into an XY plane of the second station for motion according to the first motion instruction and then the second module prints the transversal LED retaining walls on the target substrate in the second station.

According to the printing device for the LED retaining wall of the display panel provided by the present disclosure, the motion control system is specifically configured to control the adsorption apparatus to move in the XY plane under the condition that the target station includes the first station or the second station, so that the target multi-needle module prints the longitudinal LED retaining walls on the target substrate in the target station; and
send a second motion instruction to the target station, so as to drive the adsorption apparatus to move in the XY plane after the target station is rotated by 90° according to the second motion instruction, so that the target multi-needle module prints the transversal LED retaining walls on the target substrate in the target station.

According to the printing device for the LED retaining wall of the display panel provided by the present disclosure, there are one or more Z-axis controllers.

The present disclosure further provides a printing method of an LED retaining wall of a display panel, including:
performing preparation operation before printing oriented to a printing task, and scanning, by a measuring system of a printing device for the LED retaining wall of the display panel, a target substrate, to obtain flatness data of the target substrate;
moving, by a motion control system, a target multi-needle module to an initial printing point of the target substrate, and adjusting, by a Z-axis controller, a printing receiving distance of the target multi-needle module based on the received flatness data; and
performing, by the target multi-needle module, laminated printing on an upper surface of the target substrate on a target station based on preset air pressure parameters and a target line width, to generate a target LED retaining wall by curing under the condition that a printing height is within a range of a target height;
wherein, the target station includes a first station and/or a second station, the target LED retaining wall includes transversal LED retaining walls and longitudinal LED retaining walls, the target multi-needle module includes a first module and/or a second module, the printing height is a cumulative layer height corresponding to the number of printing layers, and the printing task at least includes determination of the target line width and the target height according to the target substrate.

According to the printing method for the LED retaining wall of the display panel provided by the present disclosure, the adjusting, by the Z-axis controller, the printing receiving distance of the target multi-needle module based on the received flatness data includes:
obtaining a vertical distance between each printing point of the target substrate and the target multi-needle module based on the flatness data and a target corresponding relation as an actual value of the printing receiving distance; and
adjusting, by the Z-axis controller, the actual value of the printing receiving distance into a target value of the printing receiving distance when the target multi-needle module is located at the corresponding printing point;
wherein, the target value of the printing receiving distance corresponding to each printing point is the same.

According to the printing method for the LED retaining wall of the display panel provided by the present disclosure, the performing the preparation operation before printing includes:
installing printer heads on syringes after filling the syringes with printing materials, and connecting the syringes with fluid control systems by the printer heads; and
controlling, by a control terminal, the motion control system to perform mechanical zeroing operation;
wherein, the printing materials are matched with a width-height ratio of a formed product of the printing materials, internal diameter parameters of the printer heads are matched with the target line width, and the number of printing layers is set based on the width-height ratio of the target LED retaining wall, the target line width and the target height.

According to the printing method for the LED retaining wall of the display panel provided by the present disclosure, before the target multi-needle module is moved by the motion control system to the initial printing point of the target substrate, pre-printing is performed under the preset air pressure parameters till printer heads deliver the materials stably, and an adsorption apparatus is controlled by the motion control system to leave a pre-printing zone.

According to the printing method for the LED retaining wall of the display panel provided by the present disclosure, the performing, by the target multi-needle module, laminated printing on the upper surface of the target substrate on the target station based on the preset air pressure parameters and the target line width, to generate the target LED retaining wall by curing under the condition that the printing height is within the range of the target height includes:
performing, by the first module, laminated printing on the upper surface of the target substrate on the first station based on the preset air pressure parameters and the target line width, to generate the longitudinal LED retaining walls under the condition that the printing height conforms to the target height; and
performing, by the second module, laminated printing on the upper surface of the target substrate on the second station based on the preset air pressure parameters and the target line width, to generate the transversal LED retaining walls under the condition that the printing height conforms to the target height.

According to the printing method for the LED retaining wall of the display panel provided by the present disclosure, the performing, by the target multi-needle module, laminated printing on the upper surface of the target substrate on the target station based on the preset air pressure parameters and the target line width, to generate the target LED retaining wall by curing under the condition that the printing height is within the range of the target height includes:
performing, by the target multi-needle module, laminated printing on the upper surface of the target substrate on the first station or the second station based on the preset air pressure parameters and the target line width, to generate the longitudinal LED retaining walls under the condition that the printing height conforms to the target height; and
rotating the first station or the second station by 90°, and performing, by the target multi-needle module, laminated printing on the upper surface of the target substrate, to generate the transversal LED retaining walls under the condition that the printing height conforms to the target height.

The present disclosure further provides an electronic device, including a memory, a processor and computer programs stored on the memory and capable of running on the processor. When implementing the programs, the processor implements any above printing method for the LED retaining wall of the display panel.

The present disclosure further provides a computer readable storage medium storing computer programs thereon. When implemented by a processor, the computer programs implement any above printing method for the LED retaining wall of the display panel.

The present disclosure further provides a computer program product including computer programs. When implemented by a processor, the computer programs implement any above printing method for the LED retaining wall of the display panel.

According to the printing device and method for the LED retaining wall of the display panel provided by the present disclosure, the Z-axis controller controls the target multi-needle module to control the motion process of the target substrate in the XY plane by the motion control system in the target station, such that after the printing receiving distance of the target multi-needle module at each printing point is adjusted, the target LED retaining wall with a consistent width and high perpendicularity is manufactured in the target substrate by laminated printing via a direct-writing 3D printing technology. The manufacturing efficiency and precision of the LED retaining wall can be improved. Then, retaining walls with consistent heights and widths are built around subpixels, the contrast of an LED display screen can be improved while light leakage is avoided, and gains for Mini-LED products and Micro-LED products are more obvious.

The present disclosure provides a high-precision printing device for an LED packaging retaining wall skilled in printing the retaining wall with a large width-height ratio in order to overcome the defects in the prior art.

### SOLUTIONS TO PROBLEMS

### TECHNICAL SOLUTIONS

In order to realize the above objectives of the present disclosure, the following technical solutions are adopted by the present disclosure: A printing device for an LED packaging retaining wall, includes a machining table and a three-axis motion module arranged on the machining table, and a corresponding printer head module is connected to the three-axis motion module; the three-axis motion module includes a horizontal motion module connected to the machining table and a lifting motion module overhead arranged on the machining table, the printer head module is located on the lifting motion module, and a carrier module corresponding to the printer head module is arranged on the horizontal motion module; the carrier module includes a base, a three-axis rotary table and a vacuum sucker, all of which are arranged from bottom to top, an adsorption tank is formed on a surface of the vacuum sucker, a plurality of bosses are formed in the adsorption tank, a plurality of positioning pins are arranged at corners of the vacuum sucker, and the plurality of positioning pins are located on two adjacent side edges of the vacuum sucker; and a visual and measuring apparatus corresponding to the carrier module is further arranged on the machining table.

As an embodiment of the present disclosure, a gantry is formed on the machining table, the lifting motion module is arranged on the gantry, and the printer head module and the visual and measuring apparatus are both arranged on the gantry.

As an embodiment of the present disclosure, a plurality of exhaust holes are formed in the adsorption tank and symmetrically formed along a centre of the adsorption tank, and a vacuum pressure regulating valve communicated with the exhaust holes is installed on a lower portion of the vacuum sucker.

As an embodiment of the present disclosure, at least two positioning pins are arranged on each of the adjacent side edges of the vacuum sucker.

As an embodiment of the present disclosure, the printer head module includes a material extrusion apparatus, a printer head clamp and a printer head, all of which are sequentially connected from top to bottom, the printer head clamp is fixedly connected to the lifting motion module, the material extrusion apparatus is fixedly connected to the printer head clamp, and the printer head is connected to a bottom of the printer head clamp.

As an embodiment of the present disclosure, the printer head clamp includes a hoop support and an adapter in threaded connection with the hoop support, the adapter is connected to a bottom of the hoop support, a hoop matched with the material extrusion apparatus is formed on a top of the hoop support, and the material extrusion apparatus is locked by the hoop.

As an embodiment of the present disclosure, an upper portion of the adapter is set as a female Luer taper connected with a discharge port of the material extrusion apparatus, and a lower portion thereof is a male Luer taper connected with the printer head.

As an embodiment of the present disclosure, the printer head includes a printer head base and a ceramic needle point, and an upper portion of the needle base is set as a corresponding female Luer taper.

As an embodiment of the present disclosure, the visual and measuring apparatus includes an obliquity observation assembly and a sensing and measuring assembly, the sensing and measuring assembly is vertically connected to the gantry, and the obliquity observation assembly is obliquely arranged on a side face of the printer head module, and faces the printer head

As an embodiment of the present disclosure, a cleaning apparatus and a contact height measuring apparatus corresponding to the cleaning apparatus are further arranged on the machining table.

### BENEFICIAL EFFECTS OF THE DISCLOSURE

### BENEFICIAL EFFECTS

Compared with the prior art, the present disclosure has the following beneficial effects:
1. the PCB is adsorbed by the vacuum sucker, flatness of a surface of the PCB is improved, printing difficulty is greatly lowered, and printing efficiency is improved; the vacuum sucker is provided the adsorption tank with the size the same as that of the PCB below the PCB, achieving the absorption of the PCB; a bottom contactable region of the PCB is supported by arranging as many as bosses in the adsorption tank to avoid deformation caused by excessive adsorption, such that the flatness of the adsorbed PCB is improved; and due to the arrangement of the positioning pins, two adjacent sides of the PCB can abut against the positioning pins at the same time after the PCB moves to a certain position of the adsorption tank, such that the PCB is positioned;
2. after the printer head module is lifted to a certain position, its direct-writing printing on the PCB is achieved via motion of the horizontal motion module, such that rapid manufacturing of the LED retaining wall with the extra-small line width can be realized, and the line width may range from 10 microns to 200 microns; and
3. Manufacturing of the retaining wall with the large width-height ratio can be directly realized via multi-layer laminated printing by adjusting the lifting height of the printer head module.

### BRIEF DESCRIPTION OF THE DRAWINGS

### DESCRIPTION OF THE DRAWINGS

In order to more clearly explain the technical solutions of the present disclosure or the prior art, the drawings needed in the description of embodiments or the prior art will be briefly described below. Apparently, the drawings in the following description are merely some embodiments of the present disclosure. For those ordinarily skilled in the art, other drawings can be obtained in accordance with these drawings without involving any inventive efforts.
FIG. 1 is a schematic structural diagram of a printing device for an LED retaining wall of a display panel provided by the present disclosure;
FIG. 2 is a process flow diagram of a printing device for an LED retaining wall of a display panel provided by the present disclosure;
FIG. 3 is another process flow diagram of a printing device for an LED retaining wall of a display panel provided by the present disclosure;
FIG. 4 is a flow diagram of a printing method for an LED retaining wall of a display panel provided by the present disclosure;
FIG. 5 is a retaining wall effect diagram of a printing method for an LED retaining wall of a display panel provided by the present disclosure;
FIG. 6 is a schematic structural diagram of an electronic device provided by the present disclosure;
FIG. 7 is a schematic structural diagram of a printing device for an LED packaging retaining wall of the present disclosure;
FIG. 8 is a schematic structural diagram of a workbench;
FIG. 9 is a schematic structural diagram of a carrier module;
FIG. 10 is a schematic diagram of a use state of a carrier module;
FIG. 11 is a schematic diagram of a use state of an obliquity observation assembly;
FIG. 12 is a schematic structural diagram of a printer head clamp;
FIG. 13 is a schematic structural diagram of a printer head;
FIG. 14 is a section view of a printer head;
FIG. 15 is a schematic structural diagram of a cleaning apparatus;
FIG. 16 is a schematic diagram of a use state of a sensing and measuring assembly; and
FIG. 17 is a schematic structural diagram of a contact height measuring apparatus.

Reference signs: 1. Machining table, 1-1. Gantry, 1-2. Bottom plate, 2. Three-axis motion module, 2-1. Horizontal motion module, 2-2. Lifting motion module, 3. Carrier module, 3-1. Base, 3-2. Three-axis rotary table, 3-3. Vacuum sucker, 3-4. Adsorption tank, 3-5. Boss, 3-6. Positioning pin, 3-7. Exhaust hole, 4. Printer head module, 4-1. Material extrusion apparatus, 4-2. Needle clamp, 4-2-1. Hoop support, 4-2-2. Adapter, 4-2-3. Hoop, 4-3-1. Needle base, 4-3-2. Ceramic needle point, 4-3. Printing needle, 5. Visual and measuring apparatus, 5-1. Obliquity observation assembly, 5-2. Sensing and measuring assembly, 6. Cleaning apparatus, and 7. Contact height measuring apparatus.

### DETAILED DESCRIPTION OF THE EMBODIMENTS

### DETAILED DESCRIPTION OF THE PRESENT DISCLOSURE

In order to make the objectives, technical solutions and advantages of the present disclosure clearer, the technical solutions in the present disclosure will be described clearly and completely with reference to the drawings of the present disclosure. Apparently, the described embodiments are part of the embodiments, not all of them. All other embodiments obtained by those ordinarily skilled in the art based on the embodiments of the present disclosure without involving inventive efforts should fall within the protection scope of the present disclosure.

Terms "first", "second" and the like in the specification and claims of the present application are used for distinguishing similar objects instead of describing a specific sequence or precedence. It should be understood that data used in this way may be interchanged under appropriate conditions, such that the embodiments of the present application can be implemented in a sequence other than sequences shown as drawings or described herein. Objects distinguished by "first", "second" and the like usually belong to the same class without limiting the number of the objects, for example, there may be one or more first objects.

It should be understood that the terms used in the specification of the present disclosure are merely intended to describe the objectives of the specific embodiments instead of limiting the present disclosure. As used in the specification and the appended claims of the present disclosure, the singular forms "one", "alan" and "the" are intended to include plural forms unless otherwise indicated clearly in the context.

Terms "comprise" and "comprising" indicate the existence of described features, integers, steps, operations, elements and/or assemblies, but do not exclude the existence or addition of one or more other features, integers, steps, operations, elements, assemblies and/or sets thereof.

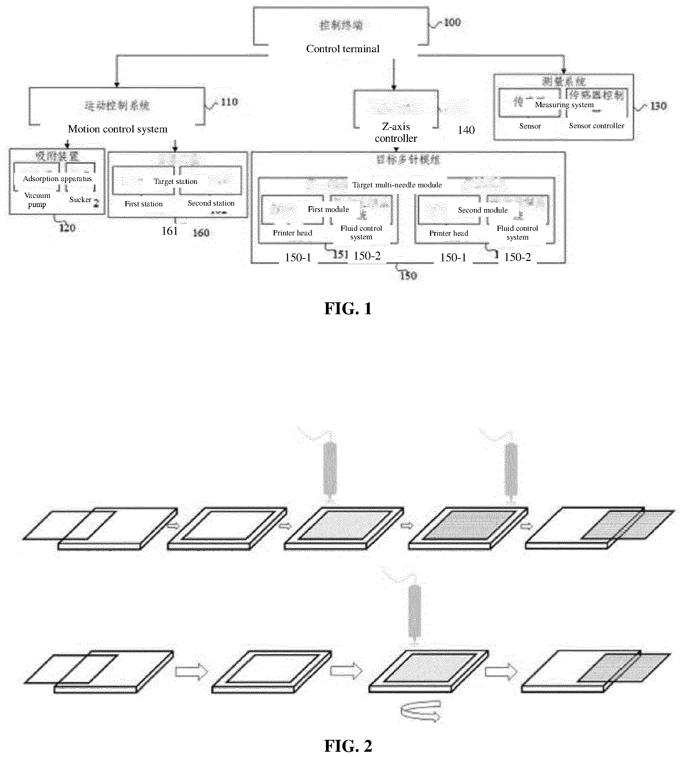

FIG. 1 is a schematic structural diagram of a printing device for an LED retaining wall of a display panel provided by the present disclosure. As shown in FIG. 1, the printing device for the LED retaining wall of the display panel provided by the present disclosure includes a motion control system 110, connected with a control terminal 100 and configured to control printing of a target LED retaining wall on an upper surface of a target substrate on a target station 160.

Wherein, the target LED retaining wall includes transversal LED retaining walls and longitudinal LED retaining walls, and the target substrate includes a PCB substrate or a glass substrate.

It should be noted that the target substrate refers to a substrate of a display panel, which is to be printed. Wherein, the display panel includes but is not limited to common LEDs, Mini-LEDs or Micro-LEDs, which is not specifically limited in the embodiment of the present disclosure.

The upper surface of the target substrate accommodates an LED light emitting array of the display panel, and the printed target LED retaining wall is used for isolating every two adjacent LED light emitting components in the LED light emitting array.

The target substrate is not specifically limited in the embodiment of the present disclosure.

For example, the target substrate may be the PCB substrate. The LED light emitting array may be formed on the PCB substrate in an arrangement manner of blue 1-green-blue 2, after the target LED retaining wall is printed in a gap between every two adjacent LED light emitting components, spaces where all the blue 1 is located are filled with fluorescent powder, and the light emitting components at the positions are converted into red light from blue light, so as to form a light emitting array of "red-green-blue".

For example, the target substrate may be the glass substrate. The target LED retaining wall may be printed on the glass substrate, which defines a plurality of accommodating parts, each accommodating part may accommodate a blue light LED, and the blue light LEDs in the corresponding accommodating spaces are covered with quantum dot light conversion films to convert the blue light LEDs into red light and green light, so as to form a light emitting array of "red-green-blue".

Specifically, the motion control system 110 in the printing device for the LED retaining wall of the display panel is connected with the control terminal 100, which may perform programming control according to different requirements to drive different components in the device to correspondingly act in corresponding process flows, such that the complete target LED retaining wall is printed in the target substrate.

Drive operation of the motion control system 110 is not specifically limited in the embodiment of the present disclosure.

Optionally, the motion control system 110 may drive the target substrate to move along an X-axis and a Y-axis of a workbench in the station, such that the target substrate is pre-printed in a pre-printing zone, and the target substrate is moved to an initial printing point in the target station 160.

Optionally, the motion control system 110 may drive the target substrate to be printed in the target station 160 at a certain motion speed, such that the target LED retaining wall is formed on the upper surface of the target substrate.

Optionally, the motion control system 110 may drive each component to zero the device. The drive operation of the motion control system 110 is not enumerated in the embodiment of the present disclosure.

An adsorption apparatus 120, connected with the motion control system 110 and configured to make a lower surface of the target substrate adsorbed onto a sucker 122 by a vacuum pump 121.

It should be noted that the vacuum pump 121 is connected with a pneumatic connector on a back surface of the sucker 122 by an air pipe. The vacuum pump 121 controls negative pressure by a vacuum electromagnetic valve to be used for supplying adsorption force to the sucker 122.

Specifically, the adsorption apparatus 120 in the printing device for the LED retaining wall of the display panel is connected with the motion control system 110, the lower surface of the target substrate is put on the sucker 122, and the vacuum electromagnetic valve is turned on to be communicated with the vacuum pump 121 after the lower surface of the target substrate completely makes contact with the sucker 122, such that flatness of the overall surface of the target substrate is improved under vacuum adsorption of the sucker 122.

A material of the sucker 122 is not specifically limited in the embodiment of the present disclosure.

For example, the material of the sucker 122 may be a metal material with certain rigidity and corrosion resistance, such as aluminum and other synthetic metals.

The material of the sucker 122 may be a non-metallic material with certain rigidity and corrosion resistance, such as ceramic, graphite or marble.

It can be understood that operations such as fixing the target substrate to the sucker, taking the target substrate down or fixing the target substrate to the sucker again may be manually completed by an operator, or completed by a mechanical arm controlled by the control terminal, which is not limited in the present disclosure.

A measuring system 130, connected with the control terminal 100 and including a sensor 131 and a sensor controller 132, the sensor 131 being configured to measure flatness data of the target substrate.

Specifically, the measuring system 130 in the printing device for the LED retaining wall of the display panel includes the sensor 131 and the sensor controller 132, both of which are respectively connected with the control terminal 100 to rapidly scan the whole target substrate and record the flatness data of the substrate.

The sensor controller 132 generates a scanning route of the sensor 131 according to an instruction received from the control terminal 100, such that the sensor 131 is perpendicular to a horizontal tabletop (namely, a plane formed by the X-axis and the Y-axis) of the station after being fixed at a certain height of a Z-axis, each printing point is traversed on the upper surface of the target substrate along the scanning route with the plane as a reference and scanned, a reference vertical distance between the sensor 131 and each printing point is recorded as the flatness data, and the flatness data is stored in a local database of the control terminal 100.

Wherein, the flatness data includes position information of each printing point and the corresponding reference vertical distance.

A type of the sensor 131 is not specifically limited in the embodiment of the present disclosure.

For example, the sensor 131 may be a distance sensor based on a Time of Flight principle, and a to-be-measured distance is obtained by a speed of modulated beams and time of round-trip propagation over the to-be-measured distance.

For example, the sensor 131 may be a distance sensor based on a geometric trigonometric optical measurement principle.

A Z-axis controller 140, connected with the control terminal 100 and configured to control a printing receiving distance between a target multi-needle module 150 and the upper surface of the target substrate.

It should be noted that the Z-axis controller 140 is connected with the control terminal 100, and the control terminal generates an adjusting strategy for the printing receiving distance by calling the locally-stored flatness data from software, and sends the strategy to the Z-axis controller 140.

Specifically, the Z-axis controller 140 in the printing device for the LED retaining wall of the display panel is connected with the target multi-needle module 150, and after receiving the adjusting strategy sent by the control terminal 100, the Z-axis controller 140 adjusts the printing receiving distance between the target multi-needle module 150 and each printing point of the upper surface of the target substrate.

The printing receiving distance refers to a reference vertical distance between the target multi-needle module 150 and any printing point of the target substrate during printing, and the printing receiving distance of each printing point is consistent based on the adjusting strategy.

The target multi-needle module 150, connected with the Z-axis controller 140 and including printer heads 150-1 and fluid control systems 150-2, the fluid control systems 150-2 being configured to supply preset air pressure parameters to the printer heads 150-1.

Wherein, the target multi-needle module 150 includes a first module 151 and/or a second module 152.

It should be noted that the target multi-needle module 150 is vertically fixed at a certain distance away from the upper surface of the target substrate by a mechanical structure.

Specifically, the target multi-needle module 150 in the printing device for the LED retaining wall of the display panel is connected with the Z-axis controller 140, so as to be driven to traverse each printing point to adjust the printing receiving distance and to perform printing according to the adjusting strategy, obtained in advance, for the printing receiving distance when the adsorption apparatus carries the target substrate to move.

Wherein, the target multi-needle module 150 includes one or more printer heads 150-1 and the fluid control systems 150-2.

Types of the printer heads 150-1 and the fluid control systems 150-2 are not specifically limited in the embodiment of the present disclosure.

For example, materials of the printer heads 150-1 include but are not limited to ceramic, glass, resin or steel, upper portions of slurry outflow passageways are wider than lower portions thereof, and the passageways can reduce resistance of slurry, so as to ensure stable discharge and identical discharge rate of each printer head of the multi-needle module. The printer heads 150-1 are set based on internal diameters of lower ports of the slurry outflow passageways. It is ensured that the printed line width of the target LED retaining wall is consistent by pre-setting completely identical internal diameter parameters for the printer heads 150-1 in the target multi-needle module 150.

The fluid control systems 150-2 may be pneumatic dispensers connected with the control terminal to control a flow rate of the slurry. It is ensured that the slurry starts to be stably discharged when extruded to each printer head 150-1 by pre-setting completely identical air pressure parameters for the printer heads 150-1 in the target multi-needle module 150.

Preferably, the target multi-needle module 150 in the printing device for the LED retaining wall of the display panel includes more than one submodule, wherein each submodule may include one or more printer heads 150-1 and fluid control systems 150-2. It is not specifically limited in the embodiment of the present disclosure.

For example, the target multi-needle module 150 may include two submodules, namely the first module 151 and the second module 152, wherein a plurality of printer heads 150-1 in the first module 151 and a plurality of printer heads 150-1 in the second module 152 are transversally arranged and longitudinally arranged respectively at preset interval parameters.

For example, the target multi-needle module 150 may include one submodule, namely the first module 151 or the second module 152, wherein the first module 151 (or the second module 152) only contains one printer head 150-1, or contains a plurality of printer heads arranged at the preset interval parameters.

The target module 160, connected with the motion control system 110 and configured to accommodate the target substrate so as to make the target multi-needle module 150 perform laminated printing of the target LED retaining wall on the upper surface of the target substrate.

Wherein, the target station 160 includes a first station 161 and/or a second station 162, the target LED retaining wall includes the transversal LED retaining walls and the longitudinal LED retaining walls, the first module 151 is matched with the first station 161, and the second module 152 is matched with the second station 162.

Specifically, the sucker 122 in the printing device for the LED retaining wall of the display panel is transferred to the horizontal tabletop (namely, the plane formed by the X-axis and the Y-axis) of the target station, such that the target substrate adsorbed by the sucker 122 is completely located within a range of the horizontal tabletop. The adsorption apparatus 120 is driven by the motion control system to drive the target substrate to move on the horizontal tabletop along a preset trajectory. Meanwhile, the target multi-needle module 150 corresponding to the target station 160 is driven by the Z-axis controller 140 to perform printing of the target LED retaining wall on the upper surface of the target substrate.

Preferably, the target station 160 in the printing device for the LED retaining wall of the display panel includes more than one station, wherein each station may accommodate the target station, and the target LED retaining wall is printed by a direct-writing 3D printing technology. It is not specifically limited in the embodiment of the present disclosure.

For example, the target station 160 may include two stations, namely the first station 161 and the second station 162, wherein the first station 161 may correspond to the first module 151, and the second station 162 may correspond to the second module 152.

After the printer heads transversally arranged in the first module 151 are fixed in the first station 161, the adsorption apparatus 120 is driven by the motion control system 110 to vertically move to a bottom end of the target substrate along each printing point on the Y-axis with an upper left position of the target substrate as an initial point, and laminated printing is performed in the back-and-forth process to generate complete longitudinal LED retaining walls.

After the needles longitudinally arranged in the first module 152 are fixed in the second station 162, the adsorption apparatus 120 is driven by the motion control system 110 to horizontally move to a right side of the target substrate along each printing point on the X-axis with the upper left position of the target substrate as the initial point, and laminated printing is performed in the back-and-forth process to generate complete transversal LED retaining walls.

For example, the target station 160 may include one station, namely the first station 161 or the second station 162. After the first module 151 (or the second module 152) is fixed, the adsorption apparatus 120 is driven by the motion control system 110 to vertically move to the bottom end with the upper left position of the target substrate as the initial point, and laminated printing is performed in the back-and-forth process to generate complete longitudinal LED retaining walls. After the first station 161 (or the second station 162) is driven by the motion control system 110 to be rotated by 90°, the adsorption apparatus 120 is driven to perform laminated printing along the same motion trajectory, to generate complete transversal LED retaining walls.

Wherein, a colour of the target LED retaining wall is not specifically limited in the embodiment of the present disclosure.

Optionally, the target LED retaining wall may have a uniform colour, such that a wall body has consistent reflectivity.

For example, as white has high reflectivity, the whole target LED retaining wall may be set as white, and white light formed by each group of LEDs is not doped with other colours, thereby greatly improving contrast and improving overall brightness. Even for the Mini-LED products and Micro-LED products with small LED gaps, the retaining wall with the consistent width and height and a uniform wall body can also be generated, and manufacturing precision and efficiency of the retaining wall are truly achieved, thereby greatly improving overall brightness and contrast.

Optionally, the target LED retaining wall may have a non-uniform colour, such that different positions of the wall body have corresponding reflectivity.

For example, in the printing process of the target LED retaining wall, a retaining wall at a bottommost layer is set as white, colour saturation is gradually increased in sequence in the layer-by-layer printing process, and a colour gradient wall body is formed, such that luminous efficiency of each LED bead is improved.

It can be understood that in a manufacturing process of the printing device for the LED retaining wall of the display panel, a coloured coating may also be arranged on an inner wall or an outer wall of the target LED retaining wall according to actual task requirements, so as to achieve corresponding effects.

For example, under the condition that LEDs cannot emit light normally, a black coating may be arranged on a top (outer wall of an upper surface) of the retaining wall, such that the black colour displayed externally is consistent. Meanwhile, under the condition that the LEDs emit light normally, the wall body with the consistent width and height can still ensure that each LED has a good reflection effect, thereby improving luminance.

In the embodiment of the present disclosure, the Z-axis controller controls the target multi-needle module to control the motion process of the target substrate in the XY plane by the motion control system in the target station, such that after the printing receiving distance of the target multi-needle module at each printing point is adjusted, the target LED retaining wall with the consistent width and high perpendicularity is manufactured in the target substrate by laminated printing via the direct-writing 3D printing technology. The manufacturing efficiency and precision of the LED retaining wall can be improved. Then, retaining walls with consistent heights and widths are built around subpixels, the contrast of an LED display screen can be improved while light leakage is avoided, and gains for the Mini-LED products and the Micro-LED products are more obvious.

On the basis of any above embodiment, the target station 160 further includes a cleaning zone, configured to clean and store the printing needles.

Specifically, after the printing device for the LED retaining wall of the display panel completes all printing tasks in the target station 160, the motion control system 110 receives an instruction from the control terminal to drive the cleaning zone to move to a position where the target multi-needle module 150 is located, such that each printer head 150-1 in the target multi-needle module 150 is soaked in a cleaning zone solvent for liquid-sealed storage at room temperature.

A pre-printing zone where pre-printing is performed under the preset air pressure parameters till the printer heads deliver the materials stably, and then the adsorption apparatus 120 is controlled by the motion control system 110 to leave the pre-printing zone.

Specifically, after the printing device for the LED retaining wall of the display panel completes a flatness scanning task by the measuring system 130 in the target station 160, the adsorption apparatus 120 is driven by the motion control system 110 to move to the pre-printing zone, and the fluid control systems 150-2 are driven by the control terminal 100 under the preset air pressure parameters; and after the slurry starts to be stably discharged (only a first piece of product needs to be pre-printed by extruding the changed slurry)when extruded to each of the plurality of printer heads, and the adsorption apparatus 120 is controlled to carry the target substrate to be transferred to the initial printing point.

In the embodiment of the present disclosure, the pre-printing zone and the cleaning zone are arranged in the target station, and operation is performed in the pre-printing zone before printing, such that the discharge speed of each printer head is consistent. Cleaning and storing are performed in the cleaning zone after printing. Service life can be prolonged when no printing task is performed, and manufacturing stability of the LED retaining wall is improved when printing tasks are performed.

On the basis of any above embodiment, the motion control system 110 is specifically configured to control the adsorption apparatus 120 to move in the XY plane under the condition that the target station 160 includes the first station 161 and the second station 162, so that the first module 151 prints the longitudinal LED retaining walls on the target substrate in the first station.

It should be noted that an application scene of the printing device for the LED retaining wall of the display panel is as follows: there are two operation stations and two multi-needle modules, a relative position relation is set for each group of operation station and multi-needle module in advance, and different multi-needle modules are used in different operation stations to perform transversal and longitudinal printing.

Specifically, the sucker 122 is driven by the motion control system 110 to be transferred into the first station 161, and the sucker 122 carries the target substrate to move in the XY plane along a preset trajectory route starting from the initial printing point of the target substrate, such that the fixed first module 151 traverses each printing point in each column of the target substrate in the first station 161 for layer-by-layer printing, to generate a plurality of complete longitudinal LED retaining walls.

It can be understood that after the adsorption apparatus 120 implements the trajectory route, that is, the first module 151 traverses all the printing points, the motion control system 110 may receive corresponding feedback information, to know that transversal LED retaining walls have been printed.

A first motion instruction is sent to the adsorption apparatus, so that the adsorption apparatus transfers the target substrate to an XY plane of the second station for moving therein according to the first motion instruction, and then the second module prints the transversal LED retaining walls on the target substrate in the second station.

Specifically, the motion control system 110 sends the first motion instruction to the adsorption apparatus 120 after knowing that the longitudinal LED retaining walls have been printed.

The first motion instruction refers to an action instruction for controlling station transfer of the adsorption apparatus 120. The first motion instruction is used for enabling the sucker 122 in the adsorption apparatus 120 to carry the target substrate on which the longitudinal LED retaining walls have been generated and transfer the target substrate into the second station 162 and driving, by the motion control system 110, the sucker 122 to carry the target substrate to move in the XY plane along the preset trajectory route starting from a last printing endpoint, such that the fixed second module 152 traverses each printing point in each row of the target substrate in the second station 162 for layer-by-layer printing, to generate a plurality of complete transversal LED retaining walls.

In the embodiment of the present disclosure, the transversal LED retaining walls and the longitudinal LED retaining walls with consistent widths and high perpendicularity are manufactured in the target substrates in the first station and the second station by the corresponding first module and second module based on the direct-writing 3D printing technology and laminated printing. The manufacturing efficiency and precision of the LED retaining wall can be improved.

On the basis of any above embodiment, the motion control system 110 is specifically configured to control the adsorption apparatus to move in the XY plane under the condition that the target station includes the first station or the second station, so that the target multi-needle module prints the longitudinal LED retaining walls on the target substrate in the target station 160.

It should be noted that an application scene of the printing device for the LED retaining wall of the display panel is as follows: there are only one operation station and one multi-needle module, and a relative position relation between the operation station and the multi-needle is changed by switching the operation station, such that transversal and longitudinal printing can be performed.

The target station may be any one of the first station 161 or the second station 162.

Correspondingly, one target multi-needle module 150 is correspondingly arranged in such station. The module may be the first module 151 in which the printer heads are transversally arranged, or the first module 152 in which the printer heads are longitudinally arranged.

Specifically, the sucker 122 is driven by the motion control system 110 to be transferred into the first station 160, and the sucker 122 carries the target substrate to move in the XY plane along the preset trajectory route starting from the initial printing point of the target substrate, such that the fixed target multi-needle module 150 traverses each printing point in each column of the target substrate in the target station 160 for layer-by-layer printing, to generate complete longitudinal LED retaining walls. It can be understood that after the target multi-needle module 150 traverses all the printing points, the motion control system 110 may receive corresponding feedback information, to know that longitudinal LED retaining walls have been printed.

A second motion instruction is sent to the target station 160, so as to drive the adsorption apparatus to move in the XY plane after the target station 160 is rotated by 90° according to the second motion instruction, so that the target multi-needle module 150 prints the transversal LED retaining walls on the target substrate in the target station 160.

Specifically, the motion control system 110 sends the second motion instruction to the target station 160 after knowing that the longitudinal LED retaining walls have been printed.

The second motion instruction refers to an action instruction for controlling rotation of the target station 160. The second motion instruction is used for enabling the target station 160 to be rotated by 90° along with the target substrate on which the longitudinal LED retaining walls have been generated, and then driving, by the motion control system 110, the sucker 122 to carry the target substrate to move in the XY plane along the preset trajectory route starting from the last printing endpoint, such that the fixed target multi-needle module 150 traverses each printing point in each row of the target substrate in the target station 160 for layer-by-layer printing, to generate a plurality of complete transversal LED retaining walls. It can be understood that there is no absolute printing sequence for the longitudinal LED retaining walls and the transversal LED retaining walls, the printing sequence is determined by the trajectory route along which the target multi-needle module 150 and the adsorption apparatus 120 carrying the target substrate move, that is, it should be ensured that an arrangement direction of the printer heads of the target multi-needle module 150 is perpendicular to a motion direction of the target substrate starting from the initial printing point.

In the embodiment of the present disclosure, the transversal LED retaining walls and the longitudinal LED retaining walls with consistent widths and high perpendicularity are respectively manufactured by the corresponding target multi-needle module in the first station or the second station through changes in the rotary direction of the first station or the second station along with the target substrate based on the direct-writing 3D printing technology and laminated printing. The manufacturing efficiency and precision of the LED retaining wall can be improved.

On the basis of any above embodiment, there are one or more Z-axis controllers 140.

Specifically, the Z-axis controllers 140 in the printing device for the LED retaining wall of the display panel are connected with the target multi-needle modules 150 in a one-to-one correspondence manner, such that the Z-axis controllers 140 can control the corresponding target multi-needle modules 150 to move along the Z axis, to adjust the printing receiving distances.

The quantity of the Z-axis controllers 140 is not specifically limited in the embodiment of the present disclosure.

Optionally, there may be one Z-axis controller 140. Correspondingly, a plurality of printer heads 151 with small outlet internal diameters are arranged at small intervals by the target multi-needle module 150. Thus, the target multi-needle module 150 is controlled by the Z-axis controller to adjust the printing receiving distance in any printing point, so as to print corresponding wall widths by the target multi-needle module 150 with the plurality of printer heads 151.

Optionally, there may be more Z-axis controllers 140. Correspondingly, the target multi-needle module 150 correspondingly connected with each Z-axis controller 140 is arranged. Each target multi-needle module 150 is provided with one printer head 151 with a large outlet internal diameter, and the plurality of target multi-needle modules 150 are arranged at large intervals. Thus, each target multi-needle module 150 is controlled by the corresponding Z-axis controller to adjust the printing receiving distance in any corresponding printing point, such that a corresponding wall width is printed by one target multi-needle module 150, and a plurality of target LED retaining walls are printed by the plurality of target multi-needle modules 150 at the same time.

In the embodiment of the present disclosure, on the basis of controlling, by one or more Z-axis controllers, the target multi-needle modules in the target station to adjust the printing receiving distances, the target LED retaining wall with the consistent width and high perpendicularity is manufactured in the target substrate by laminated printing via the direct-writing 3D printing technology. The manufacturing efficiency, precision and flexibility of the LED retaining wall can be improved.

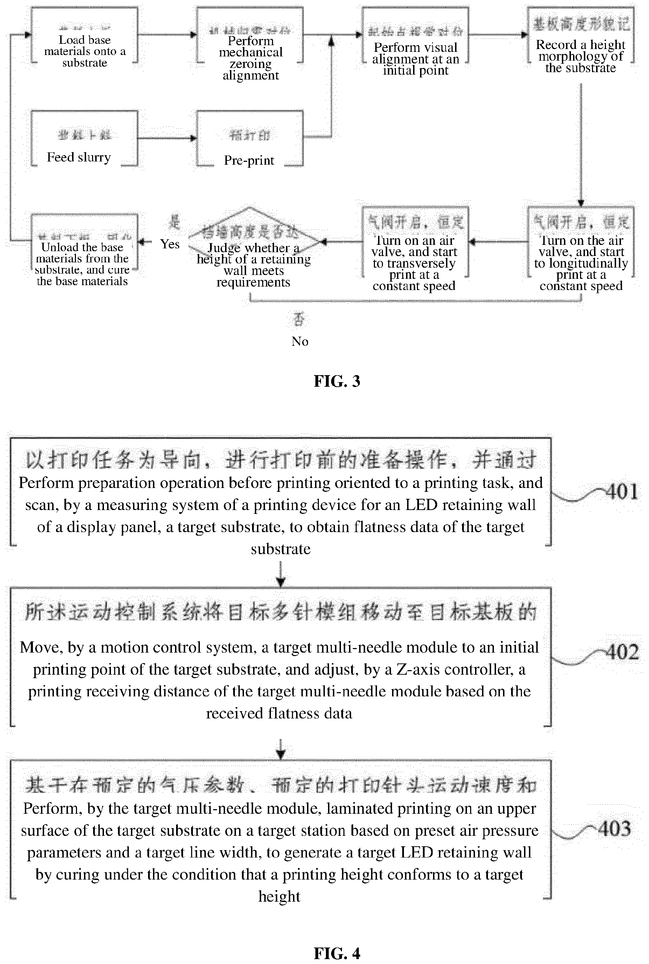

For example, FIG. 2 is a process flow diagram of the printing device for the LED retaining wall of the display panel provided by the present disclosure. FIG. 3 is another process flow diagram of the printing method for the LED retaining wall of the display panel provided by the present disclosure. As shown in FIG. 2 and FIG. 3, a specific implementation of a printing process flow of the target LED retaining walls is described.

### I. Feeding and machine preparation:

(1) syringes are installed on pneumatic dispensers after being filled with printing materials;
(2) a substrate is automatically fed in a feeding zone, automatic software is executed, a vacuum pump is started, a sucker automatically adsorbs the substrate, the ceramic sucker is automatically transferred into a station 1, and automatic mechanical zeroing alignment and levelness adjustment are achieved;
(3) the whole substrate is rapidly scanned by a high-precision height measuring instrument, and flatness data of the substrate is recorded; and
(4) the pneumatic dispensers are automatically switched on in a pre-printing zone, a flow rate is controlled by the automatic software, and a multi-needle module starts to be transferred to an initial printing point after slurry starts to be stably discharged (only a first piece of product needs to be pre-printed by extruding the changed slurry) when extruded to each of a plurality of printer heads.

### II. Sample printing:

(5) after the multi-needle modules of the transversal and longitudinal retaining walls are transferred to the initial printing point, distances between the printer heads and the substrate are automatically adjusted into a height of the retaining wall according to a control terminal vision algorithm, and the software calls the flatness data of the substrate to adjust a printing height, such that it is ensured that the distances between the printer heads and the substrate are kept consistent during printing;

(6) parameters of air valves for connecting the multi-needle modules of the transversal and longitudinal retaining walls are adjusted to be completely consistent, to ensure that printed line widths of transversal and longitudinal retaining walls are consistent;

(7) the ceramic sucker is automatically transferred into the station 1 for motion, and the transversal retaining walls are printed;

(8) the ceramic sucker is automatically transferred into a station 2 for motion, and the longitudinal retaining walls are printed;

(9) steps (6) to (8) are repeated for laminated printing till the retaining wall with a target height is printed;

(10) the vacuum pump is shut down, the substrate is cut and manually moved to a heating oven to be baked, and after the retaining wall is completely cured, a retaining wall of a single substrate has been printed; and

(11) a carrier table of the ceramic sucker is automatically transferred into the station 1, and steps (2) to (8) are repeated for subsequent sample printing.

FIG. 4 is a flow diagram of a printing method for the LED retaining wall of the display panel provided by the present disclosure. Based on any above embodiment, as shown in FIG. 4, the printing method for the LED retaining wall of the display panel includes: step 401, preparation operation before printing is performed oriented to a printing task, and a measuring system of the printing device for the LED retaining wall of the display panel scans a target substrate to obtain flatness data of the target substrate.

Wherein, the printing task at least includes determination of a target line width and a target height according to the target substrate.

It should be noted that an executive body of the printing method for the LED retaining wall of the display panel provided by the embodiment of the present disclosure is the printing device for the LED retaining wall of the display panel.

Application scenes of the printing method for the LED retaining wall of the display panel provided by the embodiment of the present disclosure are determined according to the printing task of the target substrate. Wherein, the printing task includes but is not limited to determining a printed object as the target substrate and determining the target line width and the target height of the retaining wall according to a size of each LED light emitting component in an LED light emitting array in the target substrate.

Specifically, in step 401, an operator performs feeding and machine preparation operation in the printing device for the LED retaining wall of the display panel oriented to the printing task, and after the above operation is completed, the measuring system of the printing device for the LED retaining wall rapidly scans the whole target substrate and record the flatness data of the target substrate.

The flatness data refers to a vertical distance between a sensor of the measuring system and each printing point measured when the measuring system traverses each printing point on the target substrate.

Step 402, a target multi-needle module is moved by a motion control system to an initial printing point of the target substrate, and a printing receiving distance of the target multi-needle module is adjusted by a Z-axis controller based on the received flatness data.

It should be noted that the initial printing point refers to a first printing point in the target substrate. The initial printing point is used for printing at such point to form the LED retaining wall. A relative position relation exists between a position where the initial printing point is located and the target substrate, and the initial printing point may be located at an upper left corner, an upper right corner, a lower left corner or a lower right corner of the target substrate, which is not specifically defined in the embodiment of the present disclosure.

It can be understood that the initial printing point may determine a trajectory route along which an adsorption apparatus carries the target substrate to move in an XY plane in a target station.

Specifically, in step 402, after the multi-needle module is moved by the motion control system in the printing device for the LED retaining wall of the display panel to the initial printing point of the target substrate, an adjusting strategy is generated by a control terminal vision algorithm according to the flatness data obtained in step 401, and the Z-axis controller is driven to adjust the printing receiving distance between the target multi-needle module and the target substrate according to the adjusting strategy.

The printing receiving distance refers to a vertical distance between the target multi-needle module and each printing point when the target multi-needle module traverses to each printing point in the target substrate. The printing receiving distance is not specifically limited in the embodiment of the present disclosure.

For example, if the target multi-needle module is only provided with one printer head, the printing receiving distance is the vertical distance between the printer head and any printing point.

For example, if the target multi-needle module is provided with N transversally-arranged or vertically-arranged printer heads, and a printing point array is formed by N printing points corresponding to each printer head, the printing receiving distance is the vertical distance between the target multi-needle module and the printing point array, where, N is a positive integer.

Step 403, the target multi-needle module performs laminated printing on an upper surface of the target substrate on the target station based on preset air pressure parameters and the target line width, to generate a target LED retaining wall by curing under the condition that a printing height is within a range of the target height.

Wherein, the target station includes a first station and/or a second station, the target LED retaining wall includes transversal LED retaining walls and longitudinal LED retaining walls, the target multi-needle module includes a first module and/or a second module, and the printing height is a cumulative layer height corresponding to the number of printing layers.

It should be noted that parameters set before step 403 include but are not limited to the preset air pressure parameters and the target line width.

The air pressure parameters are used for driving fluid control systems in the printing device for the LED retaining wall of the display panel to control discharging. Air pressure may be measured with the air pressure parameters in Megapascals (MPa) or Pounds per square inch (psi), which is not specifically limited in the present disclosure.

The target line width corresponds to internal diameter parameters of the printer heads, and the printer heads with different internal diameters may print retaining walls with different line widths. A value range of each parameter is not specifically limited in the embodiment of the present disclosure.

Values of the internal diameter parameters of the printer heads may range from 20 µm to 70 µm. Values of the internal diameter parameters of the printer heads are not specifically limited in the embodiment of the present disclosure as the internal diameters of the printer heads greatly affect the printed target line width.

Preferably, the values of the internal diameter parameters of the printer heads range from 45 µm to 60 µm.

A value of the target line width may range from 10 µm to 100 µm. The value of the target line width is not specifically limited in the embodiment of the present disclosure as different display panels have different subpixel intervals.

Preferably, the value of the target line width ranges from 50 µm to 80 µm.

The followings may further be set in advance:

A motion speed of the adsorption apparatus, used for driving the adsorption apparatus in the printing device for the LED retaining wall of the display panel to move.

The range of the target height, referring to a limiting condition of the printing height. The range of the target height may be a range interval divided by the target height, or a range interval formed by the target height and its acceptable tolerance range. A value of the height of the retaining wall may range from 10 µm to 200 µm. The value of the target height is not specifically limited in the embodiment of the present disclosure as different display panels have different manufacturing processes and different thicknesses.

Preferably, the value of the target height ranges from 150 µm to 200 µm.

Specifically, in step 403, the air pressure parameters, a motion speed of the printer heads and the target line width are set for the printing device for the LED retaining wall of the display panel in advance, after which the printer heads of the target multi-needle module are driven to move from the initial printing point to a last printing point in a row or column where the point is located on the target substrate, to generate a first printing layer based on a corresponding line width and layer height, and in this way, a plurality of printing layers are laminated and cured to form the target LED retaining wall.

The target LED retaining wall includes the transversal LED retaining walls and the longitudinal LED retaining walls, both of which have different sizes. Wherein, a width of the target LED retaining wall is the target line width, and a height of the target LED retaining wall is the printing height, namely a product of the number of printing layers and the layer height. A length of the target LED retaining wall is a product of the motion speed and motion time of the printer heads.

Preferably, the air pressure parameters, the motion speed of the printer heads and the target line width are set for the printing device for the LED retaining wall of the display panel in advance, the printer heads are driven to generate the first printing layer based on the corresponding line width and layer height, after the plurality of printing layers are laminated, the measuring system is used for rapidly scanning to obtain an actual value of the printing height, the actual value is compared to the range of the target height set in the printing task, and comparison results include comparison success and comparison failure, wherein,

Comparison success indicates that if the actual value of the printing height formed by laminated printing is within the range of the target height, that is, a difference therebetween is equal to 0 or close to 0, the target substrate can be cut and moved into the heating oven to be baked, and after the retaining wall is completely cured, the target LED retaining wall of the target substrate is printed completely.

Comparison failure indicates that if the actual value of the printing height formed by laminated printing is not within the range of the target height, that is, the difference therebetween goes beyond the acceptable tolerance range, the target substrate needs to be further machined according to the actual failure condition till meeting cutting standards.

FIG. 4 is a retaining wall effect diagram of the printing method for the LED retaining wall of the display panel provided by the present disclosure. As shown in FIG. 4, the embodiment of the present disclosure shows a schematic shape diagram of the target LED retaining wall formed by curing after the target substrate is cut.

It can be understood that materials can also be cured by infrared light, and the effect achieved by baking in the high-temperature baking oven for 1 hour can be achieved in a few moments, thereby improving curing efficiency. In addition, an infrared light curing apparatus is small in size and capable of being easily integrated into the printing device, such that the device has high an integration level.

Besides, the printing materials are also selective, wherein the printing materials usually are not conductive, which may be silica gel, epoxy resin and other materials.

In the embodiment of the present disclosure, the Z-axis controller controls the target multi-needle module to control the motion process of the target substrate in the XY plane by the motion control system in the target station, such that after the printing receiving distance of the target multi-needle module at each printing point is adjusted, the target LED retaining wall with a consistent width and high perpendicularity is manufactured in the target substrate by laminated printing via the direct-writing 3D printing technology. The manufacturing efficiency and precision of the LED retaining wall can be improved. Then, retaining walls with consistent heights and widths are built around subpixels, the contrast of an LED display screen can be improved while light leakage is avoided, and gains for Mini-LED products and Micro-LED products are more obvious.

On the basis of any above embodiment, adjusting the printing receiving distance of the multi-needle module based on the received flatness data includes: a vertical distance between each printing point of the target substrate and the target multi-needle module is obtained based on the flatness data and a target corresponding relation as an actual value of the printing receiving distance.

It should be noted that the target corresponding relation refers to a relative position relation between the sensor in the measuring system and the target multi-needle module.

Specifically, the printing device for the LED retaining wall of the display panel calls the flatness data of the substrate, converts the distance between the sensor and the corresponding printing point into the vertical distance between the target multi-needle module and the corresponding printing point according to the target corresponding relation, and takes the vertical distance as the actual value of the printing receiving distance.

The actual value of the printing receiving distance is adjusted into a target value of the printing receiving distance by the Z-axis controller when the target multi-needle module is located at the printing point.

Wherein, the target value of the printing receiving distance corresponding to each printing point is the same.

It should be noted that the target value of the printing receiving distance needs to be set in advance. For example, the target value of the printing receiving distance may be set when the printing task is defined.

Specifically, when the printing device for the LED retaining wall of the display panel actually implements the printing task, and after the adsorption apparatus carriers each printing point in the target substrate to align with the target multi-needle module, the target multi-needle module is driven by the Z-axis controller to adjust the actual value of the printing receiving distance into the target value along a Z axis in the printing point (namely, the fixed X-axis coordinate and Y-axis coordinate), such that each printer head performs printing at the same printing receiving distance at the corresponding printing point after the actual value is adjusted into the target value.

In the embodiment of the present disclosure, the target multi-needle module is controlled by the Z-axis controller to perform direct-writing 3D printing at the same printing receiving distance at each printing point in the target station. Errors caused by out of flatness of the target substrate can be eliminated, thereby improving manufacturing efficiency and precision of the LED retaining wall.

On the basis of any above embodiment, the preparation operation before printing is performed, including: after the syringes are filled with the printing materials, the printing needles are installed on the syringes, and the syringes and the fluid control systems are connected by the printing needles.

Wherein, the printing materials are matched with a width-height ratio of a formed product of the printing materials, the internal diameter parameters of the printer heads are matched with the target line width, and the number of printing layers is set based on the width-height ratio of the target LED retaining wall, the target line width and the target height.

It should be noted that the target line width of the printed LED retaining wall is determined by material characteristics of the printing materials, pressure applied by the fluid control systems and the internal diameter parameters of the printer heads jointly.

The printing materials refer to fluid materials with certain viscosity, which can be cured after being treated. A value of viscosity of the printing materials may range from 400000 cP to 800000 cP. The viscosity of the printing materials is not specifically limited in the embodiment of the present disclosure due to different requirements of the printing tasks.

Preferably, the viscosity of the printing materials may range from 500000 cP to 600000 cP.

Specifically, in step 401, the syringes are filled with the appropriate printing materials oriented to the target line width in the printing task according to a corresponding relation between the viscosity of the printing materials and the width-height ratio of the formed product printed by the printer heads, the printer heads are installed at lower ends of the syringes, and face downwards, and the printing materials are controlled by the fluid control systems to flow out of the printer heads, to form printing layers with sizes being the line width corresponding to the internal diameter parameters and the layer height derived from the width-height ratio.

It can be understood that before the actual printing task, the number of printing layers can also be obtained by dividing the target height by the layer height derived from the line width and the width-height ratio. Then when the printing task is actually implemented, and after printing the printing layers with the specified number, the printing height formed by laminating is compared to the target height, so as to judge whether the printing task has been completed or not.

It can be understood that the printing materials need to be blended into corresponding colours as the retaining wall is in a pure colour or gradient colour.

For example, the printing materials are blended into white, the syringes are filled with the printing materials for layer-by-layer printing, and a white retaining wall with the consistent width and height can be generated.

For example, when the first layer is printed, the printing materials are blended into white for printing, then residual materials in the syringes are cleaned away after the printing materials are moved to a cleaning zone, printing materials with gradually-increased colour saturation are injected for printing a second layer, and in this way, a colour gradient retaining wall with the consistent width and height is generated.

The motion control system is controlled by the control terminal to perform mechanical zeroing operation.

Specifically, before the printing device for the LED retaining wall of the display panel implements each printing task, the automatic software is executed at the control terminal to drive the motion control system to perform automatic mechanical zeroing alignment and levelness adjustment on a machine device.

In the embodiment of the present disclosure, appropriate printing materials are selected and mechanical zeroing is implemented before printing. Materials can be selected according to different printing requirements, such that conditions under which different printing tasks are implemented are consistent, thereby improving the manufacturing efficiency and precision of the LED retaining wall.

On the basis of any above embodiment, before the target multi-needle module is moved by the motion control system to the initial printing point of the target substrate, pre-printing is performed under the preset air pressure parameters till the printer heads deliver the materials stably, and the adsorption apparatus is controlled by the motion control system to leave a pre-printing zone.

Specifically, before the printing device for the LED retaining wall of the display panel actually implements the printing task, the fluid control systems are driven at the preset air pressure parameters to control the flow rate of the printing materials in the pre-printing zone, and after the slurry starts to be stably discharged (only a first piece of product needs to be pre-printed by extruding the changed slurry) when extruded to each printer head, the adsorption apparatus is controlled by the motion control system to transfer the target substrate to the initial printing point.

In the embodiment of the present disclosure, operation is performed in the pre-printing zone, such that the discharge speed of each printer head is consistent. Manufacturing stability of the LED retaining wall is improved when the printing task is performed.

On the basis of any above embodiment, the performing, by the target multi-needle module, laminated printing on the upper surface of the target substrate on the target station based on the preset air pressure parameters and the target line width, to generate the target LED retaining wall under the condition that the printing height conforms to the target height includes: laminated printing is performed on the upper surface of the target substrate on the first station by the first module based on the preset air pressure parameters and the target line width, to generate transversal LED retaining walls under the condition that the printing height is within the range of the target height.

It should be noted that an application scene of the printing device for the LED retaining wall of the display panel is as follows: there are two operation stations and two multi-needle modules, a relative position relation is set for each operation station and each multi-needle module in advance, and different multi-needle modules are used in different operation stations to perform transversal and longitudinal printing.

Specifically, in step 403, the sucker carries the target substrate to be transferred into the first station, and the motion control system is controlled by the control terminal to drive the sucker to carry the target substrate to move in the XY plane along a preset trajectory route at a certain speed starting from the initial printing point of the target substrate. Meanwhile, the appropriate first module is configured according to the preset target line width, and the control terminal controls the setting of the preset air pressure parameters to the fluid control systems, such that the first module traverses each printing point in each column of the target substrate in the first station, and layer-by-layer printing is performed after the printing receiving distance is adjusted along the Z axis at the printing point, to generate a plurality of complete longitudinal LED retaining walls. It can be understood that after the first module traverses all the printing points, the motion control system may receive corresponding feedback information, to know that transversal LED retaining walls have been printed. A first motion instruction is sent to the adsorption apparatus, so that the adsorption apparatus transfers the target substrate into the second station according to the first motion instruction, and then the second module prints the transversal LED retaining walls.

Laminated printing is performed on the upper surface of the target substrate on the second station by the second module based on the preset air pressure parameters and the target line width, to generate the transversal LED retaining walls under the condition that the printing height is within the range of the target height.

Specifically, the sucker in the adsorption apparatus carries the target substrate on which the longitudinal LED retaining walls have been generated to be transferred into the second station, and the motion control system is controlled by the control terminal to drive the sucker to carry the target substrate to move in the XY plane along the preset trajectory route at a certain speed starting from a last printing endpoint of the target substrate. Meanwhile, the appropriate second module is configured according to the preset target line width, and the control terminal controls the setting of preset air pressure parameters to the fluid control systems, such that the second module traverses each printing point in each row of the target substrate in the second station, and layer-by-layer printing is performed after the printing receiving distance is adjusted along the Z axis at the printing point, to generate a plurality of complete transversal LED retaining walls. It can be understood that there is no absolute printing sequence for the longitudinal LED retaining walls and the transversal LED retaining walls, the printing sequence is determined by the trajectory route along which the target multi-needle module and the adsorption apparatus carrying the target substrate move, that is, it should be ensured that an arrangement direction of the printer heads of the target multi-needle module is perpendicular to a motion direction of the target substrate starting from the initial printing point.

In the embodiment of the present disclosure, the transversal LED retaining walls and the longitudinal LED retaining walls with consistent widths and high perpendicularity are manufactured in the target substrates in the first station and the second station by the corresponding first module and second module based on the direct-writing 3D printing technology and laminated printing. The manufacturing efficiency and precision of the LED retaining wall can be improved.

On the basis of any above embodiment, the performing, by the target multi-needle module, laminated printing on the upper surface of the target substrate on the target station based on the preset air pressure parameters and the target line width, to generate the target LED retaining wall under the condition that the printing height is within the range of the target height includes: laminated printing is performed on the upper surface of the target substrate on the first station or the second station by the first module based on the preset air pressure parameters and the target line width, to generate longitudinal LED retaining walls under the condition that the printing height conforms to the target height.

It should be noted that an application scene of the printing device for the LED retaining wall of the display panel is as follows: there are only one operation station and one multi-needle module, and a relative position relation between the operation station and the multi-needle is changed by switching the operation station, such that transversal and longitudinal printing can be performed.

The target station may be any one of the first station or the second station.

Correspondingly, one target multi-needle module is correspondingly arranged in such station. The module may be the first module in which the printer heads are transversally arranged, or the second module in which the printer heads are longitudinally arranged.

Specifically, the sucker is transferred into the target station, and the motion control system is controlled by the control terminal to drive the sucker to carry the target substrate to move in the XY plane along the preset trajectory line at a certain speed starting from the initial printing point of the target substrate. Meanwhile, the appropriate target multi-needle module is configured according to the preset target line width, and the control terminal controls the setting of the preset air pressure parameters to the fluid control systems, such that the target multi-needle module traverses each printing point in each column of the target substrate in the first target station, and layer-by-layer printing is performed after the printing receiving distance is adjusted along the Z axis at the printing point, to generate a plurality of complete longitudinal LED retaining walls. It can be understood that after the target multi-needle module traverses all the printing points, the motion control system may receive corresponding feedback information, to know that the transversal LED retaining walls have been printed. A second motion instruction is sent to the target station, so that the target multi-needle module prints the transversal LED retaining walls after the target station is rotated by 90° according to the second motion instruction.

The first station or the second station is rotated by 90°, and laminated printing is performed on the upper surface of the target substrate by the target multi-needle module, to generate the longitudinal LED retaining walls under the condition that the printing height conforms to the target height.

Specifically, after the target station is rotated by 90° along with the target substrate on which the transversal LED retaining walls have been generated, the motion control system is controlled by the control terminal to drive the sucker to carry the target substrate to move in the XY plane along the preset trajectory line at a certain speed starting from a last printing endpoint of the target substrate. Meanwhile, the appropriate target multi-needle module is configured according to the preset target line width, and the control terminal controls the setting of the preset air pressure parameters to the fluid control systems, such that the target multi-needle module traverses each printing point in each column of the target substrate in the target station, and layer-by-layer printing is performed after the printing receiving distance is adjusted along the Z axis at the printing point, to generate a plurality of complete transversal LED retaining walls.

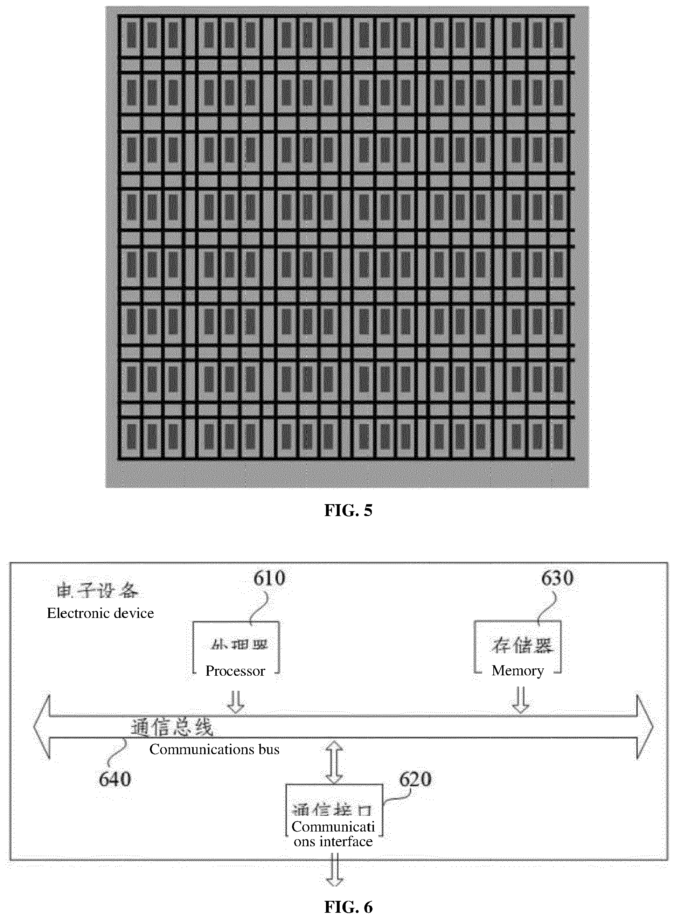

FIG. 5 is a retaining wall effect diagram of the printing method for the LED retaining wall of the display panel provided by the present disclosure. For example, as shown in FIG. 5, after the corresponding process flow is implemented via the printing method for the LED retaining wall, retaining walls with consistent widths and heights can be established around three single LEDs in each group of LEDs on the substrate.

In the embodiment of the present disclosure, the transversal LED retaining walls and the longitudinal LED retaining walls with consistent widths and high perpendicularity are respectively manufactured by the corresponding target multi-needle module in the first station or the second station through changes in the rotary direction of the first station or the second station along with the target substrate based on the direct-writing 3D printing technology and laminated printing. The manufacturing efficiency and precision of the LED retaining wall can be improved.

FIG. 6 shows a schematic diagram of a physical structure of an electronic device. As shown in FIG. 6, the electronic device may include: a processor 610, a communications interface 620, a memory 630 and a communications bus 640, wherein the processor 610, the communication interface 620 and the memory 630 communicate with one another via the communications bus 640. The processor 610 can call logic instructions in the memory 630, to implement the printing method for the LED retaining wall of the display panel. The method includes: preparation operation is performed before printing oriented to a printing task, and a measuring system of a printing device for the LED retaining wall of the display panel scans a target substrate, to obtain flatness data of the target substrate; a target multi-needle module is moved by a motion control system to move to an initial printing point of the target substrate, and a printing receiving distance of each printer head in the target multi-needle module is adjusted by a Z-axis controller based on the received flatness data; and laminated printing is performed on an upper surface of the target substrate on a target station by the target multi-needle module based on preset air pressure parameters, a preset motion speed of the printer heads, and a target line width, to generate a target LED retaining wall by curing under the condition that a printing height is within a range of a target height; wherein, the target station includes a first station and/or a second station, the target LED retaining wall includes transversal LED retaining walls and longitudinal LED retaining walls, the target multi-needle module includes a first module and/or a second module, the printing height is a cumulative layer height corresponding to the number of printing layers, and the printing task at least includes determination of the target line width and the target height according to the target substrate.

In addition, when implemented in the form of software function units and sold or used as independent products, the logic instructions in the above memory 630 may be stored in a computer readable storage medium. Based on such understanding, the technical solution of the present disclosure essentially or the part making contributions to the prior art or the part of technical solution may be shown in the form of a software product, and the computer software product is stored on a storage medium, including a plurality of instructions configured to enable a computer device (which may be a personal computer, a server, a network device or the like) to implement all or part of steps of the method in each embodiment of the present disclosure. The above storage medium includes: a USB flash drive, a removable hard disk, a Read-Only Memory (ROM), a Random Access Memory (RAM), a magnetic disk, a compact disk and other various media on which program codes can be stored.

In another aspect, the present disclosure further provides a computer program product. The computer program product includes computer programs capable of being stored on a non-transient computer readable storage medium. When implemented by a processor, the computer programs can implement the printing method for the LED retaining wall of the display panel provided by each above method. The method includes: preparation operation is performed before printing oriented to a printing task, and a measuring system of a printing device for the LED retaining wall of the display panel scans a target substrate, to obtain flatness data of the target substrate; a target multi-needle module is moved by a motion control system to move to an initial printing point of the target substrate, and a printing receiving distance of each printer head in the target multi-needle module is adjusted by a Z-axis controller based on the received flatness data; and laminated printing is performed on an upper surface of the target substrate on a target station by the target multi-needle module based on preset air pressure parameters and a target line width, to generate a target LED retaining wall by curing under the condition that a printing height is within a range of a target height; wherein, the target station includes a first station and/or a second station, the target LED retaining wall includes transversal LED retaining walls and longitudinal LED retaining walls, the target multi-needle module includes a first module and/or a second module, the printing height is a cumulative layer height corresponding to the number of printing layers, and the printing task at least includes determination of the target line width and the target height according to the target substrate.

In yet another aspect, the present disclosure further provides a non-transient computer readable storage medium storing computer programs thereon. When implemented by a processor, the computer programs can implement the printing method for the LED retaining wall of the display panel provided by each above method. The method includes: preparation operation is performed before printing oriented to a printing task, and a measuring system of a printing device for the LED retaining wall of the display panel scans a target substrate, to obtain flatness data of the target substrate; a target multi-needle module is moved by a motion control system to move to an initial printing point of the target substrate, and a printing receiving distance of each printer head in the target multi-needle module is adjusted by a Z-axis controller based on the received flatness data; and laminated printing is performed on an upper surface of the target substrate on a target station by the target multi-needle module based on preset air pressure parameters and a target line width, to generate a target LED retaining wall by curing under the condition that a printing height is within a range of a target height; wherein, the target station includes a first station and/or a second station, the target LED retaining wall includes transversal LED retaining walls and longitudinal LED retaining walls, the target multi-needle module includes a first module and/or a second module, the printing height is a cumulative layer height corresponding to the number of printing layers, and the printing task at least includes determination of the target line width and the target height according to the target substrate.

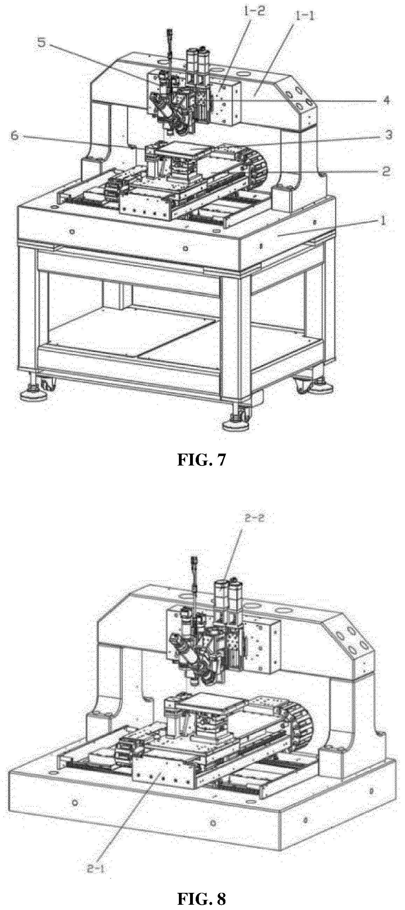

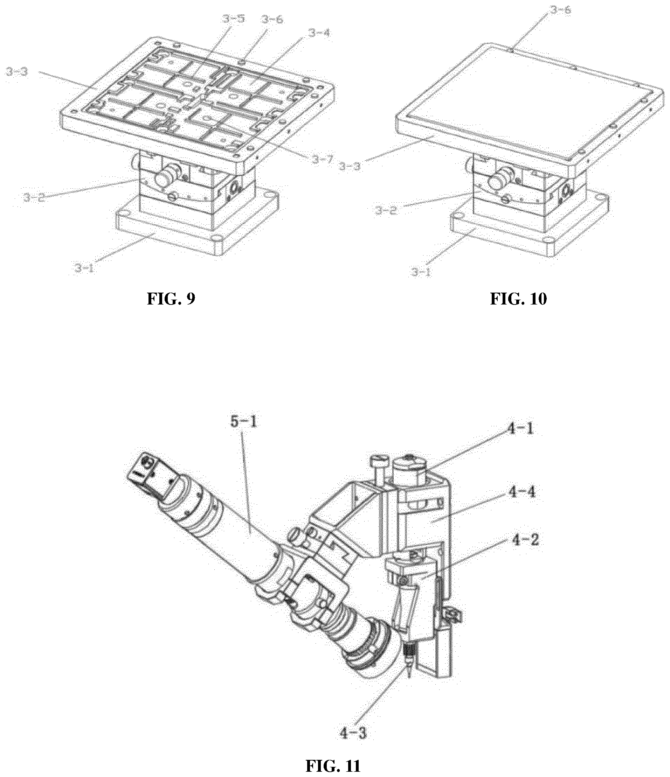

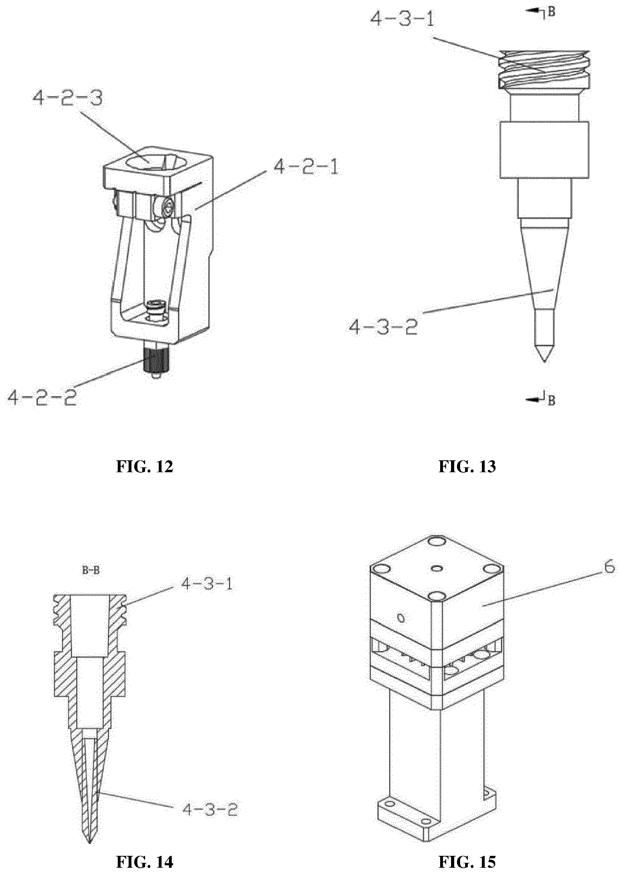

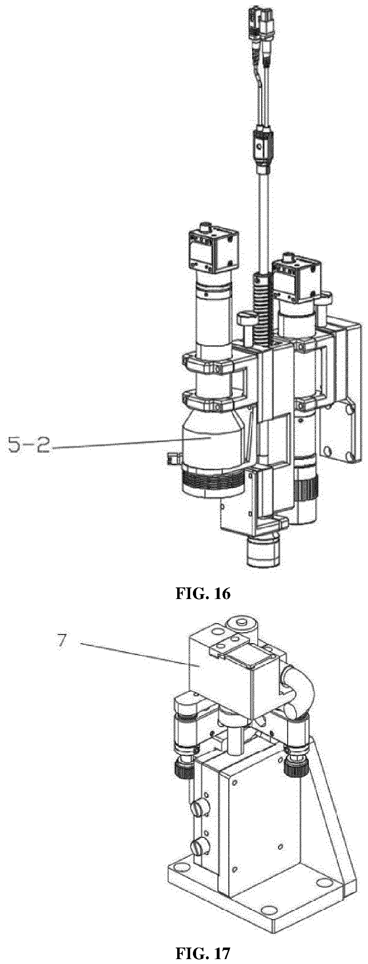

As shown in FIGS. 7-17, a printing device for an LED packaging retaining wall includes a machining table 1 and a three-axis motion module 2 arranged on the machining table 1, and a corresponding printer head module 4 is connected to the three-axis motion module 2; the three-axis motion module 2 includes a horizontal motion module 2-1 connected to the machining table 1 and a lifting motion module 2-2 overhead arranged on the machining table 1, the printer head module 4 is located on the lifting motion module 2-2, and a carrier module 3 corresponding to the printer head module 4 is arranged on the horizontal motion module 2-1; the carrier module 3 includes a base 3-1, a three-axis rotary table 3-2 and a vacuum sucker 3-3, all of which are arranged from bottom to top, an adsorption tank 3-4 is formed on a surface of the vacuum sucker 3-3, a plurality of bosses 3-5 are formed in the adsorption tank 3-4, a plurality of positioning pins 3-6 are arranged at corners of the vacuum sucker 3-3, and the plurality of positioning pins 3-6 are located on two adjacent side edges of the vacuum sucker 3-3; and a visual and measuring apparatus 5 corresponding to the carrier module 3 is further arranged on the machining table 1.

The horizontal motion module 2-1 includes an X-axis motion apparatus and a Y-axis motion apparatus connected with the X-axis motion apparatus. The X-axis motion apparatus is installed on the machining table 1, the Y-axis motion apparatus is installed on the X-axis motion apparatus, motion directions of the X-axis motion and the Y-axis motion apparatus are perpendicular to each other, the X-axis motion apparatus and the Y-axis motion apparatus are both driven by a linear motor, and the lifting motion module 2-2 is driven by a servo motor.

A bottom plate 1-2 is arranged on a gantry 1-1, the visual and measuring apparatus 5, the printer head module 4 and the lifting motion module 2-2 are all arranged on the bottom plate 1-2, and matching holes corresponding to the visual and measuring apparatus 5, the printer head module 4 and the lifting motion module 2-2 are formed in the bottom plate 1-2, positions thereof depending on actual requirements.

The gantry 1-1 is formed on the machining table 1, the lifting motion module 2-2 is arranged on the gantry 1-1, and the printer head module 4 and the visual and measuring apparatus 5 are both arranged on the gantry 1-1.

A plurality of exhaust holes 3-7 are formed in the adsorption tank 3-4 and symmetrically formed along a centre of the adsorption tank 3-4, and a vacuum pressure regulating valve communicated with the exhaust holes 3-7 is installed on a lower portion of the vacuum sucker 3-3. An air connector is installed on the lower portion of the vacuum sucker 3-3 to be communicated with the vacuum pressure regulating valve to obtain stable and adjustable vacuum pressure, such that it is ensured that a PCB is stably adsorbed onto the carrier module 3.

At least two positioning pins 3-6 are arranged on each of the adjacent side edges of the vacuum sucker 3-3, the vacuum sucker 3-3 is of a rectangular structure, the adsorption tank 3-4 is also of a rectangular structure corresponding to the vacuum sucker 3-3, centres of the vacuum sucker 3-3 and the adsorption tank 3-4 correspond to each other, and the positioning pins 3-6 are arranged on two adjacent side edges of the adsorption tank 3-4. Under the action of the positioning pins 3-6, the PCB moves on the adsorption tank 3-4, and after it moves to a certain position, two side edges thereof abut against the positioning pins 3-6 at the same time, such that the PCB is positioned.

Bosses 3-5 are staggered from components on the printed circuit board, which are used for supporting the PCB. The bosses 3-5 are arranged at positions where no components of the PCB are arranged as many as possible, such that the PCB can be better supported by the bosses 3-5. Negative pressure exists between the vacuum sucker 3-3 and the PCB during adsorption of the vacuum sucker 3-3, such that excessive deformation caused by pressing the PCB is avoided under the action of the bosses 3-5.

During actual use, the convex bosses 3-5 are arranged in an adsorption zone of the vacuum sucker 3-3 for supporting the PCB. As a large number of components are pasted on a back surface of the PCB, the appearance of the bosses 3-5 is designed according to the appearance of the PCB, and the bosses 3-5 correspond to positions where the PCB is flat, free of components and can be in contact. The bosses are arranged at the positions where no components are arranged as many as possible in design, such that good supporting is obtained to ensure adsorption flatness.

The three-axis rotary table 3-2 is a standard part, which has a three-axis manual rotation function and is used for leveling the vacuum sucker 3-3. The vacuum sucker 3-3 is made of an aluminum alloy, and its surface is finished, such that it has high flatness, thereby improving an adsorption flatness effect of the PCB.

The printer head module 4 includes a material extrusion apparatus 4-1, a printer head clamp 4-2, a printer head 4-3 and a printing base 4-4, wherein the printer head clamp 4-2 is fixedly connected to the lifting motion module 2-2, the printing base 4-4 is connected with the lifting motion module 2-2, an upper portion of the printer head clamp 4-2 is connected to the material extrusion apparatus 4-1, and a lower portion thereof is connected with the printer head 4-3.

The material extrusion device 4-1 is configured to control extrusion of the printing materials, it is driven by compressed air and controls extrusion pressure of the materials by controlling pressure of the compressed air, and the pressure of the compressed air is controlled by a precision air pressure controller. A discharge port of the material extrusion apparatus 4-1 is set as a male Luer taper, and the material extrusion apparatus 4-1 is fixed to the printer head clamp 4-2 by a hoop.

The printer head clamp 4-2 includes a hoop support 4-2-1 and an adapter 4-2-2 in threaded connection with the hoop support, both of which are used for fixedly connecting the material extrusion apparatus 4-1 and the printer head 4-3 respectively, the adapter 4-2-2 is connected to a bottom of the hoop support 4-2-1, the hoop 4-2-3 matched with the material extrusion apparatus 4-1 is formed on a top of the hoop support 4-2-1, the hoop 4-2-3 is matched with the material extrusion apparatus 4-1 in size, and the material extrusion apparatus 4-1 is locked under the action of the hoop 4-2-3.

An upper portion of the adapter 4-2-2 is set as a female Luer taper connected with the discharge port of the material extrusion device 4-1, and a lower portion thereof is a male Luer taper connected with the printer head 4-3.

The printer head 4-3 includes a printer head base 4-3-1 and a ceramic needle point 4-3-2 connected with the printer head base. The printer head base 4-3-1 and the ceramic needle point 4-3-2 are bonded by epoxy resin, and can bear pressure within 1000 pi. An upper portion of the printer head base 4-3-1 is set as a corresponding female Luer taper, the printer head 4-3 is connected with the printer head clamp 4-2 by the Luer tapers, and they are stably connected through thread tightening and conical surface sealing inside the Luer tapers. A lower half portion of the printer head base 4-3-1 and the ceramic needle point 4-3-2 are bonded by the epoxy resin, the ceramic needle point 4-3-2 is obtained by precision ceramic casting and grinding processes, and its hole diameter may range from 10 microns to 200 microns, so as to meet printing requirements of retaining walls with different widths.

The visual and measuring apparatus 5 includes an obliquity observation assembly 5-1 and a sensing and measuring assembly 5-2, the sensing and measuring assembly 5-2 is vertically connected to the gantry 1-1, and the obliquity observation assembly 5-1 is obliquely arranged on a side face of the printer head module 4, and faces the printer head 4-3.

The obliquity observation assembly 5-1 is installed on the side face of the printer head module 4 and provided with a high-magnification camera assembly for observation, and the high-magnification camera assembly includes a camera, a lens cone and an object lens. The camera assembly is installed on a camera clamp, and the camera clamp is provided with a three-axis manual adjusting apparatus. The obliquity observation assembly 5-1 includes an annular light source and a backlight source, both of which are used for illumination. The annular light source is installed on the object lens by a hoop, and the backlight source is installed below the printer head module 4.

Meanwhile, the hoop of the obliquity observation assembly 5-1 is connected to the printer head module 4 by the three-axis manual adjusting apparatus. When the printer head module 4 rises and falls to a certain height, the obliquity observation assembly 5-1 is adjusted by adjusting the three-axis manual adjusting apparatus, such that the obliquity observation assembly 5-1 corresponds to the ceramic needle point 4-3-2. The obliquity observation assembly 5-1 includes a corresponding high-magnification camera assembly, which can magnify the ceramic needle point 4-3-2, such that the operator can directly observe a printing condition of the ceramic needle point 4-3-2 conveniently.

The sensing and measuring assembly 5-2 is installed on the bottom plate 1-2 and located on one side of the obliquity observation assembly 5-1. The sensing and measuring assembly 5-2 includes a high-magnification camera assembly for visual alignment, a laser distance sensor for height measuring, and a large-view camera assembly for observing a printing effect. The high-magnification camera assembly includes a camera, a lens cone with coaxial light, and an object lens, and it is installed on the bottom plate 1-2 by a manual adjusting slide platform. The laser distance sensor is installed on the high-magnification camera assembly by a manual adjusting slide platform. The large-view camera assembly is installed on the laser distance sensor by a manual adjusting slide platform.

A cleaning apparatus 6 and a contact height measuring apparatus 7 corresponding to the cleaning apparatus are further arranged on the machining table 1. The cleaning apparatus 6 is driven by compressed air, and the compressed air is blown out of the cleaning apparatus 6 via annular slits, so as to obtain annular high-speed airflow. An operation flow of the cleaning apparatus 6 is as follows: a machine is operated to make a tip of the printer head inserted into a hole in a top of the cleaning apparatus 6, and a compressed air source is switched on; under the action of the high-speed airflow, materials left on an outer wall of the printer head are taken away; and the printer head is lifted at a constant speed, such that the high-speed airflow can evenly blow over the outer wall of the printer head.

A contact sensor, an angular displacement adjusting mechanism and a lifting adjusting mechanism are arranged on the contact height measuring apparatus 7.

The lifting adjusting mechanism is a Z-axis horizontal lifting displacement slide platform with a crossed guide rail, is formed in a manner that a high-strength aluminum alloy is subjected to sand blasting and black anodic oxidation, and then assembled with a high-precision crossed roller guide rail, is suitable for light and heavy loads, can be frequently adjusted, and is a direct moving platform with excellent properties. The angular displacement adjusting mechanism 7-6 may adopt an OMO-VM cylindrical V-type adjusting frame, is provided with two M6×0.25 fine-pitch propellers, and can achieve precise adjusting of ±3°. The fine-pitch propellers are designed with flexible locking mechanisms used for ensuring long-term reliability.

The contact sensor is leveled under the action of the angular position adjusting mechanism and the lifting adjusting mechanism, the laser distance sensor measures a machining face and the contact height measuring apparatus 7, to obtain a height relation between the machining face and the contact height measuring apparatus 7, and the ceramic needle point 4-3-2 of the printer head module 4 makes contact with the contact height measuring apparatus 7, to obtain a height relation between the ceramic needle point 4-3-2 and the contact height measuring apparatus 7. Then a height relation between the ceramic needle point 4-3-2 and the machining face is obtained by calculation. An interval between the ceramic needle point 4-3-2 of the printer head module 4 and the machining face is controlled by adjusting a falling quantity of the printer head module 4, such that a printing height of the printer head module 4 can be conveniently adjusted.

Those skilled in the art can achieve or use the present disclosure according to the above description of the disclosed embodiments. Various modifications to these embodiments will be apparent to those skilled in the art, and general principles limited herein can be achieved in other embodiments without departing from the spirit or scope of the present disclosure. Thus, the present disclosure will not be limited to these embodiments shown herein, but will conform to the widest scope consistent with principles and novel features disclosed herein.

The use of other terms is not excluded though more terms with reference signs in the figures are used herein: 1. Machining table, 1-1. Gantry, 2. Three-axis motion module, 2-1. Horizontal motion module, 2-2. Lifting motion module, 3. Carrier module, 3-1. Base, 3-2. Three-axis rotary table, 3-3. Vacuum sucker, 3-4. Adsorption tank, 3-5. Boss, 3-6. Positioning pin, 3-7. Exhaust hole, 4. Printer head module, 4-1. Material extrusion apparatus, 4-2. Printer head clamp, 4-2-1. Hoop support, 4-2-2. Adapter, 4-2-3. Hoop, 4-3-1. Printer head base, 4-3-2. Ceramic needle point, 4-3. Printer head, 5. Visual and measuring apparatus, 5-1. Obliquity observation assembly, 5-2. Sensing and measuring assembly, 6. Cleaning apparatus, and 7. Contact height measuring apparatus. These terms are used merely to more conveniently describe and explain the essence of the present disclosure. To interpret them as any additional limitation is contrary to the spirit of the present disclosure.

The apparatus embodiment described above is only illustrative, wherein units illustrated as separating components may be or may not be physically separated, and components displayed as units may be or may not be physical units, may be located in one place, or may be distributed on a plurality of network units. Part or all of modules may be selected therefrom according to actual requirements to achieve the objectives of the solutions of the embodiments. Those ordinarily skilled in the art can understand and implement the embodiments without involving inventive efforts.

Those skilled in the art can clearly understand that each implementation may be achieved by means of software and essential general hardware platforms or may be certainly achieved by hardware according to the description of the implementations. Based on such understanding, the technical solutions in essence or the part making contributions to the prior art may be shown in the form of a software product, and the control terminal software product may be stored on a control terminal readable storage medium, such as an ROM/RAM (Read Only Memory/Random Access Memory), a magnetic disk and a compact disk, including a plurality of instructions configured to enable a control terminal device (may be a personal control terminal, a server, or a network device and the like) to implement the methods according to embodiments or some parts of the embodiments.

Finally, it should be noted that the above embodiments are merely used for illustrating the technical solutions of the present disclosure instead of limiting them. Although the present disclosure is illustrated in detail with reference to the above embodiments, those ordinarily skilled in the art should understand that they can still modify the technical solutions recorded in the above embodiments, or equivalently substitute part of technical features therein. These modifications or substitutions cannot make the essence of the corresponding technical solutions depart from the spirit and scope of the technical solutions of the embodiments of the present disclosure.

## Claims

1. A printing method for an LED retaining wall of a display panel, **characterized by** comprising: performing preparation operation before printing oriented to a printing task, and scanning, by a measuring system of a printing device for the LED retaining wall of the display panel, a target substrate, to obtain flatness data of the target substrate;
moving, by a motion control system, a target multi-needle module to an initial printing point of the target substrate, and adjusting, by a Z-axis controller, a printing receiving distance of the target multi-needle module based on the received flatness data; and
performing, by the target multi-needle module, laminated printing on an upper surface of the target substrate on a target station based on preset air pressure parameters and a target line width, to generate a target LED retaining wall by curing under the condition that a printing height is within a range of a target height;
wherein, the target station comprises a first station and/or a second station, the target LED retaining wall comprises transversal LED retaining walls and longitudinal LED retaining walls, the target multi-needle module comprises a first module and/or a second module, the printing height is a cumulative layer height corresponding to the number of printing layers, and the printing task at least comprises determination of the target line width and the target height according to the target substrate.

2. The printing method for the LED retaining wall of the display panel according to claim 1, **characterized in that** the adjusting, by the Z-axis controller, the printing receiving distance of the target multi-needle module based on the received flatness data comprises:
obtaining a vertical distance between each printing point of the target substrate and the target multi-needle module based on the flatness data and a target corresponding relation as an actual value of the printing receiving distance; and
adjusting, by the Z-axis controller, the actual value of the printing receiving distance into a target value of the printing receiving distance when the target multi-needle module is located at the corresponding printing point;
wherein, the target value of the printing receiving distance corresponding to each printing point is the same.

3. The printing method for the LED retaining wall of the display panel according to claim 1, **characterized in that** the performing the preparation operation before printing comprises:
installing printer heads on syringes after filling the syringes with printing materials, and connecting the syringes with fluid control systems by the printer heads; and controlling, by a control terminal, the motion control system to perform mechanical zeroing operation; wherein, the printing materials are matched with a width-height ratio of a formed product of the printing materials, internal diameter parameters of the printer heads are matched with the target line width, and the number of printing layers is set based on the width-height ratio of the target LED retaining wall, the target line width and the target height.

4. The printing method for the LED retaining wall of the display panel according to claim 3, **characterized in that** before the target multi-needle module is moved by the motion control system to the initial printing point of the target substrate, pre-printing is performed under the preset air pressure parameters till the printer heads deliver the materials stably, and an adsorption apparatus is controlled by the motion control system to leave a pre-printing zone.

5. The printing method for the LED retaining wall of the display panel according to claim 1, **characterized in that** the performing, by the target multi-needle module, laminated printing on the upper surface of the target substrate on the target station based on the preset air pressure parameters and the target line width, to generate the target LED retaining wall by curing under the condition that the printing height is within the range of the target height comprises: performing, by the first module, laminated printing on the upper surface of the target substrate on the first station based on the preset air pressure parameters and the target line width, to generate the longitudinal LED retaining walls under the condition that the printing height conforms to the target height; and
performing, by the second module, laminated printing on the upper surface of the target substrate on the second station based on the preset air pressure parameters and the target line width, to generate the transversal LED retaining walls under the condition that the printing height conforms to the target height.

6. The printing method for the LED retaining wall of the display panel according to claim 1, **characterized in that** the performing, by the target multi-needle module, laminated printing on the upper surface of the target substrate on the target station based on the preset air pressure parameters and the target line width, to generate the target LED retaining wall by curing under the condition that the printing height is within the target height range comprises: performing, by the target multi-needle module, laminated printing on the upper surface of the target substrate on the first station or the second station based on the preset air pressure parameters and the target line width, to generate the longitudinal LED retaining walls under the condition that the printing height conforms to the target height; and
rotating the first station or the second station by 90°, and performing, by the target multi-needle module, laminated printing on the upper surface of the target substrate, to generate the longitudinal LED retaining walls under the condition that the printing height conforms to the target height.

7. A non-transient computer readable storage medium, storing computer programs thereon, **characterized in that** when implemented by a processor, the computer programs implement the printing method for the LED retaining wall of the display panel according to any one of claims 1-6.

8. A printing device for an LED retaining wall of a display panel, **characterized by** comprising a motion control system, connected with a control terminal and configured to control printing of a target LED retaining wall on an upper surface of a target substrate on a target station;
an adsorption apparatus, connected with the motion control system and configured to make a lower surface of the target substrate adsorbed onto a sucker by a vacuum pump;
a measuring system, connected with the control terminal and comprising a sensor and a sensor controller, the sensor being configured to measure flatness data of the target substrate; a Z-axis controller, connected with the control terminal and configured to control a printing receiving distance between a target multi-needle module and the upper surface of the target substrate;
the target multi-needle module, connected with the Z-axis controller and comprising printer heads and fluid control systems, the fluid control systems being configured to supply preset air pressure parameters to the printer heads; and
the target station, connected with the motion control system and configured to accommodate the target substrate so as to make the target multi-needle module perform laminated printing of the target LED retaining wall on the upper surface of the target substrate;
wherein, the target station comprises a first station and/or a second station, the target LED retaining wall comprises transversal LED retaining walls and longitudinal LED retaining walls, the target multi-needle module comprises a first module and/or a second module, the first module is matched with the first station, the second module is matched with the second station, and the target substrate comprises a PCB (printed circuit board) substrate or a glass substrate.

9. The printing device for the LED retaining wall of the display panel according to claim 8, **characterized in that** the target station further comprises:
a cleaning zone, configured to clean and store the printer heads; and
a pre-printing zone, configured to pre-print at the preset air pressure parameters till the printer heads deliver the materials stably, and then the adsorption apparatus is controlled by the motion control system to leave the pre-printing zone;
the motion control system is specifically configured to control the adsorption apparatus to move in an XY plane under the condition that the target station comprises the first station and the second station, so that the first module prints the longitudinal LED retaining walls on the target substrate in the first station; and
send a first motion instruction to the adsorption apparatus, so that the adsorption apparatus transfers the target substrate into an XY plane of the second station for motion according to the first motion instruction and then the second module prints the transversal LED retaining walls on the target substrate in the second station;
the motion control system is specifically configured to control the adsorption apparatus to move in the XY plane under the condition that the target station comprises the first station or the second station, so that the target multi-needle module prints the longitudinal LED retaining walls on the target substrate in the target station; and
send a second motion instruction to the target station, so as to drive the adsorption apparatus to move in the XY plane after the target station is rotated by 90° according to the second motion instruction, so that the target multi-needle module prints the transversal LED retaining walls on the target substrate in the target station; and
there are one or more Z-axis controllers.

10. A printing device for an LED packaging retaining wall, **characterized by** comprising a machining table and a three-axis motion module arranged on the machining table, a corresponding printer head module being connected to the three-axis motion module, wherein the three-axis motion module comprises a horizontal motion module connected to the machining table and a lifting motion module arranged across the machining table, the printer head module is located on the lifting motion module, and a carrier module corresponding to the printer head module is arranged on the horizontal motion module; the carrier module comprises a base, a three-axis rotary table and a vacuum sucker, all of which are arranged from bottom to top, an adsorption tank is formed on a surface of the vacuum sucker, a plurality of bosses are formed in the adsorption tank, a plurality of positioning pins are arranged at corners of the vacuum sucker, and the plurality of positioning pins are located on two adjacent side edges of the vacuum sucker; and a visual and measuring apparatus corresponding to the carrier module is further arranged on the machining table.

11. The printing device for the LED packaging retaining wall according to claim 10, **characterized in that** a gantry is formed on the machining table, the lifting motion module is arranged on the gantry, and the printer head module and the visual and measuring apparatus are both arranged on the gantry;
a plurality of exhaust holes are formed in the adsorption tank and symmetrically formed along a centre of the adsorption tank, and a vacuum pressure regulating valve communicated with the exhaust holes is installed on a lower portion of the vacuum sucker;
at least two positioning pins are arranged on each of the adjacent side edges of the vacuum sucker;
the printer head module comprises a material extrusion apparatus, a printer head clamp and a printer head, all of which are sequentially connected from top to bottom, the printer head clamp is fixedly connected to the lifting motion module, the material basic apparatus is fixedly connected to the printer head clamp, and the printer head is connected to a bottom of the printer head clamp;
the printer head clamp comprises a hoop support and an adapter in threaded connection with the hoop support, the adapter is connected to a bottom of the hoop support, a hoop matched with the material extrusion apparatus is formed on a top of the hoop support, and the material extrusion apparatus is locked by the hoop;
an upper portion of the adapter is set as a female Luer taper connected with a discharge port of the material extrusion device, and a lower portion thereof is a male Luer taper connected with the printer head;
the printer head comprises a printer head base and a ceramic needle point, and an upper portion of the printer head base is set as a corresponding female Luer taper;
the visual and measuring apparatus comprises an obliquity observation assembly and a sensing and measuring assembly, the sensing and measuring assembly is vertically connected to the gantry, and the obliquity observation assembly is obliquely arranged on a side face of the printer head module, and faces the printer head; and
a cleaning apparatus and a contact height measuring apparatus corresponding to the cleaning apparatus are further arranged on the machining table.
